# EUROPÄISCHE PATENTANMELDUNG

(11) **EP 2 270 894 A1**
(43) Veröffentlichungstag der Anmeldung: **05.01.2011**
(21) Anmeldenummer: 10176990.9
(22) Anmeldetag: 03.02.2004
(51) Int. Cl.: H01L 51/30

(54) **Verwendung von organischen mesomeren Verbindungen als Dotanden**

(30) Priorität: 04.12.2003 DE 10357044
(62) Teilanmeldung aus: 09002596.6
(71) Anmelder: Novaled AG, 01307 Dresden (DE)
(72) Erfinder: Kühl, Olaf, 04416, Markkleeberg (DE); Zeika, Olaf, 06727, Theißen (DE); Zheng, Youxuan, 01069, Dresden (DE); Hartmann, Horst, 01326, Dresden (DE); Pfeiffer, Martin, 01139, Dresden (DE)
(74) Vertreter: Scholz, Volker

(57) **Zusammenfassung**

Die Erfindung betrifft eine Verwendung einer organischen mesomeren Verbindung als organischer Dotand zur Dotierung eines organischen halbleitenden Matrixmaterials zur Veränderung der elektrischen Eigenschaften desselben, wobei die mesomere Verbindung ein Chinon oder Chinonderivat ist und die mesomere Verbindung unter gleichen Verdampfungsbedingungen eine geringer Flüchtigkeit als Tetrafluorotetracyanochinondimethan (F4TCNQ) aufweist, wobei die Flüchtigkeit der mesomeren Verbindung das 0,9-fache, bevorzugt das 0,8-fache von F4TCNQ oder weniger beträgt, und wobei das molare Dotierungsverhältnis von Dotand zu Matrixmolekül bzw. monomeren Einheit eines polymeren Matrixmoleküls zwischen 1:5 und 1:1000 beträgt.

## Beschreibung

Die Erfindung betrifft die Verwendung von organischen mesomeren Verbindungen als Dotanden zur Dotierung eines organischen halbleitenden Matrixmaterials zur Veränderung der elektrischen Eigenschaften desselben, ein dotiertes halbleitende Matrixmaterial sowie ein aus diesem hergestelltes elektronisches Bauelement.

Schon seit einigen Jahrzehnten ist das Dotieren von Siliziumhalbleitern Stand der Technik. Danach wird durch Erzeugung von Ladungsträgern im Material eine Erhöhung der zunächst recht niedrigen Leitfähigkeit sowie je nach Art des verwendeten Dotanden eine Veränderung im Fermi-Niveau des Halbleiters erreicht.

Seit einigen Jahren ist nun aber auch bekannt geworden, dass man organische Halbleiter ebenfalls durch Dotierung hinsichtlich ihrer elektrischen Leitfähigkeit stark beeinflussen kann. Solche organischen halbleitenden Matrixmaterialien können entweder aus Verbindungen mit guten Elektronendonator-Eigenschaften oder aus Verbindungen mit guten Elektronenakzeptor-Eigenschaften aufgebaut werden. Zum Dotieren von Elektronendonator-Materialien sind starke Elektronen-Akzeptoren wie Tetracyanochinondimethan (TCNQ) oder 2,3,5,6-Tetrafluorotetracyano-1,4-benzochinondimethan (F4TCNQ) bekannt geworden. M. Pfeiffer, A. Beyer, T. Fritz, K. Leo, Appl. Phys. Lett., 73 (22), 3202-3204 (1998). und J. Blochwitz, M. Pfeiffer, T. Fritz, K. Leo, Appl. Phys. Lett., 73 (6), 729-731 (1998). Diese erzeugen durch Elektronentransferprozesse in elektronendonatorartigen Basismaterialien (Löchertransportmaterialien) sog. Löcher, durch deren Anzahl und Beweglichkeit sich die Leitfähigkeit des Basismaterials mehr oder weniger signifikant verändert. Als Matrixmaterialien mit Löchertransporteigenschaften sind beispielsweise N,N'-perarylierte Benzidine **TPD** oder N,N',N"-perarylierte Starburstverbindungen, wie die Substanz **TDATA,** oder aber auch bestimmte Metallphthalocyanine, wie insbesondere Zinkphthalocyanin **ZnPc** bekannt.

Die bisher untersuchten Verbindungen haben jedoch für eine technische Anwendung Nachteile in der Produktion dotierter halbleitender organischer Schichten oder von entsprechenden elektronischen Bauteilen mit derartigen dotierten Schichten, da die Fertigungsprozesse in großtechnischen Produktionsanlagen oder solchen im Technikumsmaßstab nicht immer ausreichend präzise gesteuert werden können, was zu hohem Steuerungs- und Regelaufwand innerhalb der Prozesse führt, um eine gewünschte Produktqualität zu erzielen, oder zu unerwünschten Toleranzen der Produkte. Ferner bestehen Nachteile bei der Verwendung bisher bekannter organischer Donatoren bezüglich der elektronischen Bauelementstrukturen wie Leuchtdioden (OLEDs), Feldeffekttransistor (FET) oder Solarzellen selber, da die genannten Produktiansschwierigkeiten bei der Handhabung der Dotanden zu unerwünschten Ungleichmäßigkeiten in den elektronischen Bauteilen oder unerwünschten Alterungseffekten der elektronischen Bauteile führen können. Gleichzeitig ist jedoch zu beachten, dass die zu verwendenden Dotanden geeignete Elektronenaffinitäten und andere für den Anwendungsfall geeignete Eigenschaften aufweisen, da beispielsweise die Dotanden unter gegebenen Bedingungen auch die Leitfähigkeit oder andere elektrische Eigenschaften der organisch halbleitenden Schicht mit bestimmen.

Der Erfindung liegt daher die Aufgabe zugrunde, organische Dotanden zur Dotierung organischer Halbleiter bereitzustellen, die im Produktionsprozess leichter handhabbar sind und die zu elektronischen Bauteilen führen, deren organische halbleitende Materialien reproduzierbarer herstellbar sind.

Die erfindungsgemäße Aufgabe wird gelöst durch die Merkmale der unabhängigen Ansprüche. Bevorzugte Ausführungsformen ergeben sich aus den Unteransprüchen.

Erfindungsgemäß wird diese Aufgabe durch eine Verwendung einer organischen mesomeren Verbindung als organischer Dotand gelöst, die ein Chinon oder Chinonderivat, insbesondere ein unsubstituiertes, substituiertes oder anelliertes Chinon oder Chinonderivat, ist und die unter gleichen Verdampfungsbedingungen eine geringere Flüchtigkeit als Tetrafluorotetracyanochinondimethan (F4TCNQ) aufweist, wobei das molare Dotierungsverhältnis von Dotand zu Matrixmolekül bzw. monomeren Einheit eines polymeren Matrixmoleküls vorzugsweise zwischen 1:5 und 1:1000 beträgt. Als Chinonderivat im Sinne der Erfindung sind insbesondere chinoide Systeme zu verstehen, bei denen ein, zwei oder mehr chinoide Sauerstoffatome durch einen mesomer und/oder induktiv elektronenziehenden, doppelbindungsgebundenen Substituenten ersetzt ist/sind, insbesondere durch einen solchen weiter unten angegebenen Substituenten. Unter induktiv elektronenziehend sind solche Reste zu verstehen, die gegenüber Kohlenstoff einen, insbesondere ungesättigten, Kohlenwasserstoff einen -I-Effekt aufweisen. Durch die höhere Verdampfungstemperatur bzw. geringere Flüchigkeit unter gleichen Bedingungen können die Produktionsprozesse besser kontrolliert und damit mit geringerem Aufwand und reproduzierbarer durchgeführt werden, wobei durch die Bereitstellung von Chinonen bzw. deren Derivaten als Dotanden diese in den jeweiligen Bauteilen bei geringen Diffusionskoeffizienten, die zeitlich gleichbleibende Bauelementstrukturen gewährleisten, eine ausreichende elektrische Leitfähigkeit der organischen halbleitenden Matrix bei günstiger Elektronenaffinität der Dotanden ermöglichen. Ferner kann durch die Dotanden die Ladungsträgerinjektion von Kontakten in die dotierte Schicht verbessert werden. Ferner kann das dotierte organische Halbleitermaterial bzw. das resultierende elektronische Bauteil aufgrund der erfindungsgemäß verwendeten Verbindungen eine verbesserte Langzeitstabilität aufweisen. Dies betrifft beispielsweise eine Verringerung der Dotandenkonzentration mit der Zeit. Ferner betrifft dies die Stabilität der dotierten Schicht, die benachbart zu undotierten Schichten eines elektrooptischen Bauteils angeordnet ist, so dass elektrooptische Bauteile mit erhöhter Langzeitstabilität der elektrooptischen Eigenschaften wie Lichtausbeute bei einer vorgegebenen Wellenlänge, Wirksamkeit einer Solarzelle oder dergleichen resultieren.

Bevorzugte Fortbildungen ergeben sich aus den Unteransprüchen.

Die Flüchtigkeit kann hierbei als der unter gleichen Bedingungen (beispielsweise einem Druck von 2 x 10⁻⁴ Pa und einer vorgegebenen Verdampfungstemperatur, beispielsweise 150°C) gemessene Verdampfungsrate oder als Bedampfungsrate eines Substrats gemessen als Schichtdickenwachstum je Zeiteinheit (nm/s) unter sonst gleichen Bedingungen bestimmt werden. Vorzugsweise beträgt die Flüchtigkeit der erfindungsgemäßen Verbindungen das ≤ 0,95- oder 0,9-fache, besonders bevorzugt das ≤ 0,8-fache, weiter bevorzugt das ≤ 0,5-fache, besonders bevorzugt das ≤ 0,1-fache oder das ≤ 0,05-fache oder ≤ 0,01-fache von F4TCNQ oder weniger.

Die Bedampfungsrate des Substrats mit den erfindungsgenäßen Verbindungen kann beispielsweise unter Verwendung eines Quartzdickenmonitors bestimmt wird, wie er beispielsweise bei der Herstellung von OLEDs üblicherweise eingesetzt wird. Insbesondere kann das Verhältnis der Bedampfungsraten von Matrixmaterialien und Dotanden durch unabhängige Messungen derselben unter Verwendung von zwei getrennten Quartzdickenmonitoren gemessen werden, um das Dotierungsverhältnis einzustellen.

Die Flüchtigkeit relativ zu der von F4TCNQ kann sich jeweils auf die der reinen Verbindung oder auf die Flüchtigkeit aus einem gegebenen Matrixmaterial, beispielsweise ZnPc, beziehen.

Es versteht sich, dass die erfindungsgemäß verwendeten Verbindungen vorzugsweise derart beschaffen sind, dass sie mehr oder weniger oder praktisch unzersetzt verdampfen. Es können unter Umständen jedoch auch zielgerichtet Precursor als Dotandenquelle eingesetzt werden, die die erfindungsgemäß verwendeten Verbindungen freisetzen, beispielsweise Säureadditionssalze, beispielsweise einer flüchtigen oder nichtflüchtigen anorganischen oder organischen Säure, oder Charge-Transfer-Komplexe derselben, wobei die Säuren bzw. Elektronen-Donatoren vorzugsweise nicht oder nur gering flüchtig sind oder der Charge-Transfer-Komplex selber als Dotand wirkt.

Vorzugsweise ist der Dotand derart ausgewählt, dass er unter sonst gleichen Bedingungen wie insbesondere Dotierungskonzentration (Molverhältnis Dotand:Matrix, Schichtdicke, Stromstärke) bei gegebenem Matrixmaterial (beispielsweise Zinkphtalocyanin oder einem anderen weiter unten genannten Matrixmaterial) eine genau so hohe oder vorzugsweise eine höhere Leitfähigkeit erzeugt als F4TCNQ, beispielsweise eine Leitfähigkeit (S/cm) von größer/gleich dem 1,1-fachen, 1,2-fachen oder größer/gleich dem 1,5-fachen oder zweifachen derjenigen von F4TCNQ als Dotand.

Vorzugsweise ist der erfindungsgemäß verwendete Dotand derart ausgewählt, dass das mit diesem dotierte halbleitende organische Matrixmaterial nach einer Temperaturänderung von 100 °C auf Raumtemperatur (20°C) noch ≥ 20%, vorzugsweise ≥ 30%, besonders bevorzugt ≥ 50% oder 60% der Leitfähigkeit (S/cm) des Wertes bei 100°C aufweist.

Als Dotanden für die genannten bevorzugten Lochtransportmaterialen HT können erfindungsgemäß verschiedene Chinonderivate zum Einsatz kommen.

### Chinoide Strukturen

In erfindungsgemäß verwendeten chinoiden Verbindungen können ein, zwei, drei oder vier oder sämtliche chinoide =O-Gruppen der chinoiden Verbindung, die ein ortho- oder para-chinoides System darstellen kann, wobei bei mehrkernigen chinoiden Systemen auch gemischte ortho-para chinoide Systeme auftreten können, aus der Gruppe ausgewählt sein, wie sie nachfolgend für die Substituenten S1 bis S11, S13 bis S21 definiert sind, gegebenenfalls auch ohne S1, wobei die Substituenten untenstehend definiert sind.

Für eine erfindungsgemäß verwendete chinoide Verbindung können ein, zwei, drei, vier oder mehr oder sämtliche Substituenten für eine chinoide =O-Gruppe ausgewählt sein aus der Gruppe bestehend aus S1-S11, S14-S16, gegebenenfalls auch ohne S1, oder ausgewählt sein aus der Gruppe bestehend aus S1, S5-S14 und S16, gegebenenfalls auch ohne S1, oder ausgewählt sein aus der Gruppe bestehend aus S3, S4, S6-S10, S15, S16, gegebenenfalls auch ohne S1.

Es können auch für eine erfindungsgemäß verwendete chinoide Verbindung ein, zwei, drei, vier oder mehr oder sämtliche Substituenten für eine chinoide =O-Gruppe ausgewählt sein aus der Gruppe bestehend aus S1, S5, S7-S9, S11, S14, S16-21, gegebenenfalls auch ohne S1, oder aus der Gruppe S1, S5, S8, S9, S11, S14, S16, S18, gegebenenfalls auch ohne S1.

Insbesondere können ein, zwei, drei, vier oder mehr oder sämtliche Substituenten für eine chinoide Gruppe =O sein =C(CN)₂ oder =N(CN) oder =N(NO2) oder =C(CN)(C(O)R) oder =N(C(O)R). Vorzugsweise enthalten ein, zwei, drei oder vier oder mehr oder sämtliche chinoide Substituenten des chinoiden Systems eine mesomer verbundene -NO₂ undd/oder -C(O)R Gruppe.

Verbindungen mit folgenden chinoiden Grundgerüsten können erfindungsgemäß eingesetzt werden. 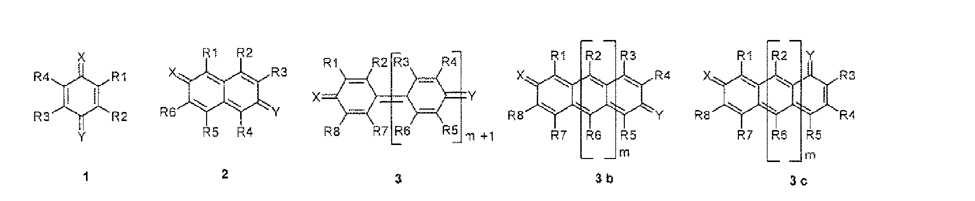 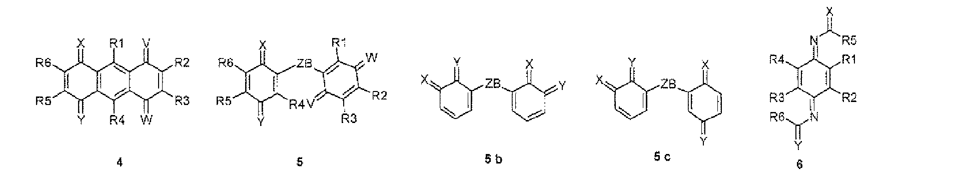 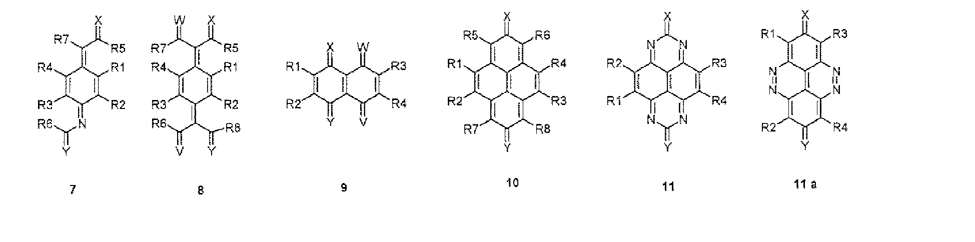 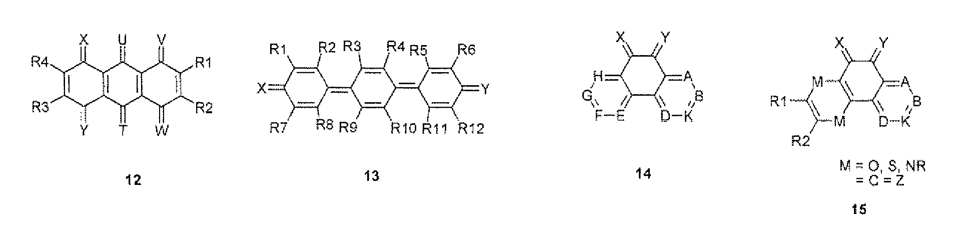 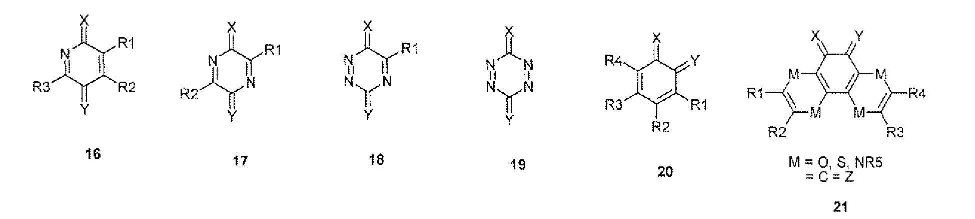 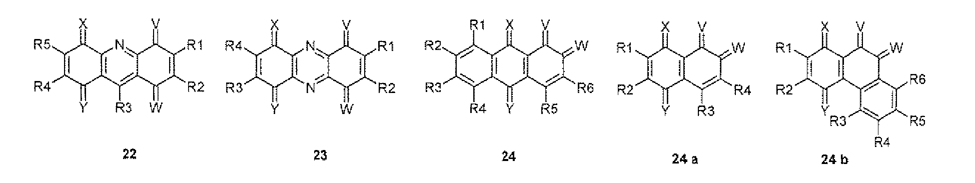 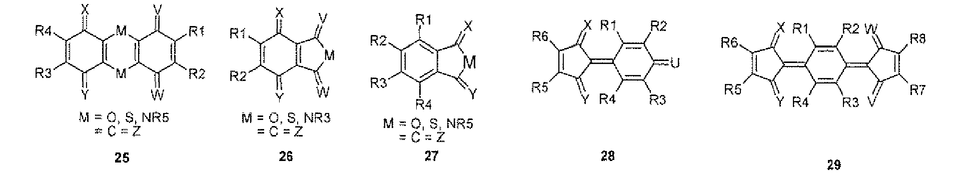 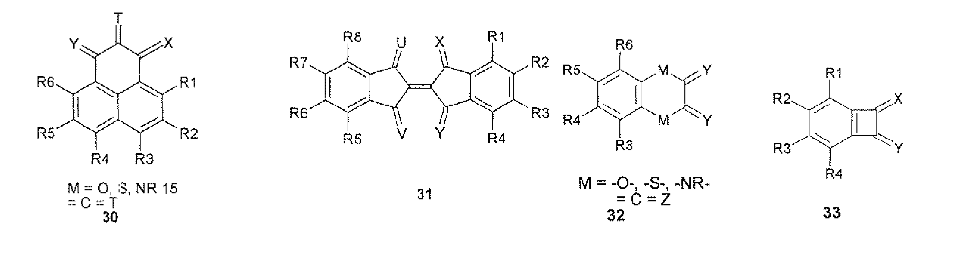 wobei in den Verbindungen 3, 3b, 3c m sein kann: 0,1,2,3,4 bis 6 oder größer,

und wobei ferner in den Verbindungen 25-27 der Substituent Z einer Gruppe M gleich oder verschieden sein kann von einem anderen Substituenten X, Y, V, W,

wobei in Verbindung 25 die beiden Gruppen M oder für M gleich =C=Z die beiden Gruppen Z gleich oder verschieden sein können, und wobei in Verbindung 32 vorzugsweise eine oder beide Gruppen M nicht =C=Z sind.

Es versteht sich, dass die angegebenen Verbindungen jeweils sämtliche Stereoisomere umfassen können, insbesondere syn- und anti-Isomere, sofern diese jeweils sterisch möglich sind.

Die Substituenten T, U, V, W, X, Y und Z stellen hierbei vorzugsweise mesomer und/oder bezogen auf Kohlenstoff oder einen Kohlenwasserstoff, insbesondere einen gesättigten Kohlenwasserstoff, induktiv ziehende doppelbindungsgebundene Substituenten dar.

Insbesondere können für die Verbindungen 1-33 die Substituenten T, U, V, W, X, Y und/oder Z jeweils unterschiedlich oder gleich sein und ausgewählt sein aus der Gruppe bestehend aus: 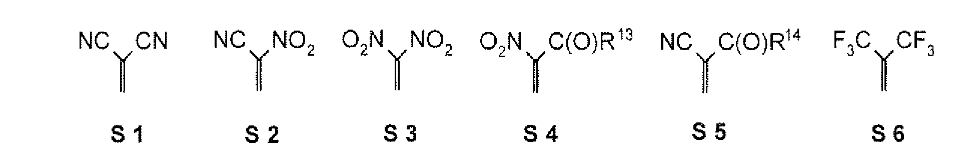 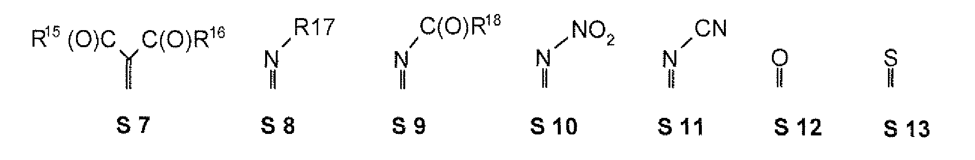 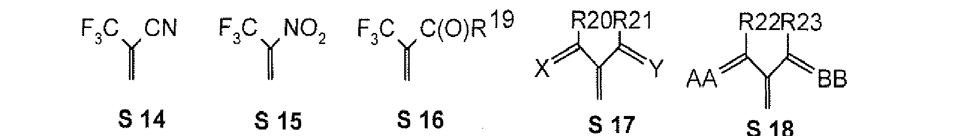 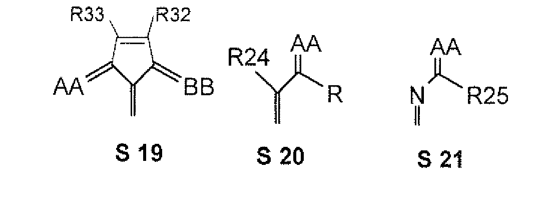 wobei R vorzugsweise ein organischer Rest oder Wasserstoff ist. R17 kann insbesondere auch -CF₃ oder Perfluoralkyl, insbesondere mit C1-C6, sein. Ist der Substituent S17, so sind X und Y des Substituenten S17 vorzugsweise nicht wiederum S17 und/oder S18 bis S21.

Die Substituenten T, U, V, W, X und/oder Z können in den Verbindungen 1-33 insbesondere jeweils gleich oder verschieden sein und ausgewählt sein aus der Gruppe bestehend aus 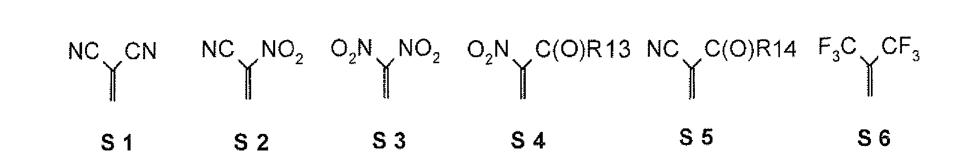 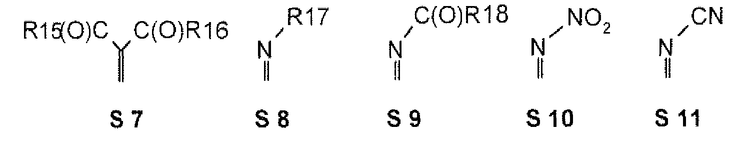 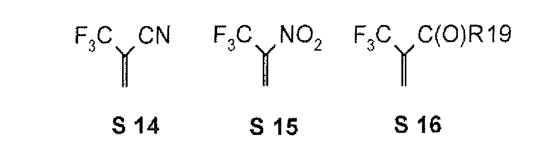 wobei R vorzugsweise ein organischer Rest oder Wasserstoff ist, wobei R17 der Gruppe S8 insbesondere auch -CF₃ oder allgemein Perfluoralkyl, insbesondere mit C1 bis C6, sein. Insbesondere können ein, zwei, drei, vier oder sämtlich der Substituenten aus dieser Gruppe ausgewählt sein. Insbesondere können X und Y gleich oder verschieden sein und X oder Y oder X und Y können aus dieser Gruppe ausgewählt sein. Insbesondere können alternativ oder zusätzlich V und W gleich oder verschieden sein und V oder W oder V und W können aus dieser Gruppe ausgewählt sein.

Die Substituenten T, U, V, W, X, Y und/oder Z können in den Verbindungen 1 bis 33 jeweils gleich oder verschieden sein und ausgewählt sein aus der Gruppe bestehend aus 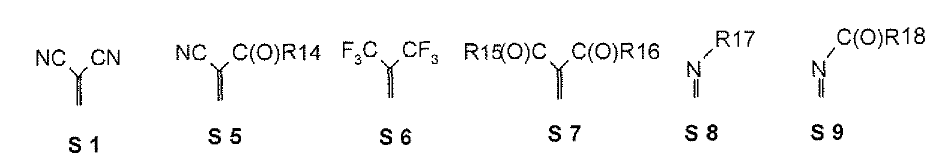 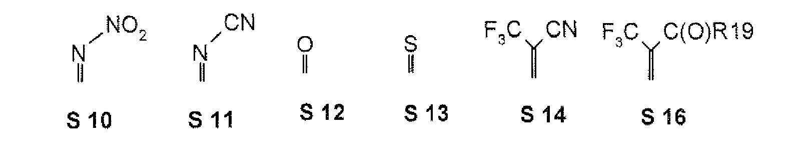 wobei R vorzugsweise ein organischer Rest oder Wasserstoff ist, wobei R17 der Gruppe S8 insbesondere auch -CF₃ oder allgemein Perifluoralkyl, insbesondere mit C1 bis C6 sein kann. Insbesondere können ein, zwei, drei, vier oder sämtliche der Substituenten aus dieser Gruppe ausgewählt sein. Insbesondere können X und Y gleich oder verschieden sein und X oder Y oder X und Y können aus dieser Gruppe ausgewählt sein. Insbesondere können alternativ oder zusätzlich V und W gleich oder verschieden sein und V oder W oder V und W können aus dieser Gruppe ausgewählt sein.

Die Substituenten T, U, V, W, X, Y und/oder Z können in den Verbindungen 1 bis 33 jeweils gleich oder verschieden sein und ausgewählt sein aus der Gruppe bestehend aus 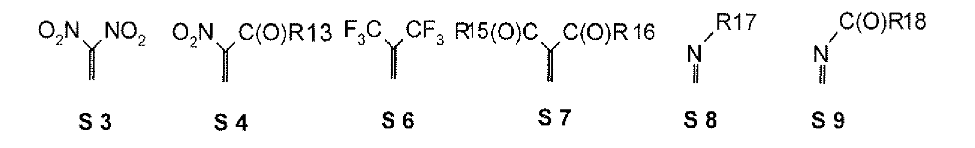 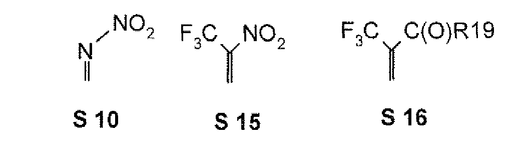 wobei R vorzugsweise ein organischer Rest oder Wasserstoff ist, wobei R17 der Gruppe S8 insbesondere auch -CF₃ oder allgemein Perfluoralkyl, insbesondere mit C1 bis C6 sein kann. Insbesondere können ein, zwei, drei, vier oder sämtliche der Substituenten aus dieser Gruppe ausgewählt sein. Insbesondere können X und Y gleich oder verschieden sein und X oder Y oder X und Y können aus dieser Gruppe ausgewählt sein. Insbesondere können alternativ oder zusätzlich V und W gleich oder verschieden sein und V oder W oder V und W können aus dieser Gruppe ausgewählt sein.

Es können die Substituenten T, U, V, W, X, Y und/oder Z in den Verbindungen 1 bis 33 auch jeweils gleich oder verschieden sein und ausgewählt sein aus der Gruppe bestehend aus S1, S5, S7-S9, S11, S14, S16-21, gegebenenfalls auch ohne S1, oder aus der Gruppe S1, S5, S8, S9, S11, S14, S16, S18, gegebenenfalls auch ohne S1. Insbesondere können ein, zwei, drei, vier oder sämtliche der Substituenten aus dieser Gruppe ausgewählt sein. Insbesondere können X und Y gleich oder verschieden sein und X oder Y oder X und Y können aus dieser Gruppe ausgewählt sein. Insbesondere können alternativ oder zusätzlich V und W gleich oder verschieden sein und V oder W oder V und W können aus dieser Gruppe ausgewählt sein.

Für die Verbindungen 1 bis 33 können die folgenden Beziehungen zwischen den Subsituenten gelten. Die folgenden Substituentenbeziehungen können insbesondere gelten für die Gruppe der Substituenten S1 bis S21. Die folgenden Substituentenbeziehungen können gelten für die Gruppe der Substituenten S1 bis S11, S14 bis S16. Die folgenden Substituentenbeziehungen können gelten für die Gruppe der Substituenten S1, S5-S14, S16. Die folgenden Substituentenbeziehungen können gelten für die Gruppe S3, S4, S6-S10, S15, S16.

Es können X und/oder Y nicht oder nicht gleichzeitig =O oder =C(CN)2 sein. Dies gilt insbesondere für einen einkernigen chinoiden Dotanden, dessen Substituenten vorzugsweise ein oder kein aromatisches Ringsystem bilden oder darstellen. Insbesondere kann dies für die Verbindungen 1 und 20 gelten. Alternativ oder zusätzlich können V und/oder W nicht oder nicht gleichzeitig =O oder =C(CN)2 sein.

Vorzugsweise sind in der erfindungsgemäß verwendeten Verbindung jeweils = X und = X gleich und/oder es sind = U und = T gleich und/oder es sind = V und = W gleich.

Vorzugweise sind jeweils die Substituenten AA und BB gleich, sie können auch verschieden voneinander sein.

Es können zumindest einer oder zwei der Substituenten aus der Gruppe = X, = Y, = U, = V, = T, = W, = Z oder sämtliche Substituenten aus der genannten Gruppe verschieden von = O sein.

Es können = X und = Y verschieden von = O sein.

Vorzugsweise ist zumindest einer oder zwei der Substituenten aus der Gruppe = X, = Y, = U, = V, = T, = W, = Z oder sämtliche Substituenten aus der Gruppe verschieden von = S.

Vorzugsweise ist zumindest einer oder beide Substituenten aus der Gruppe =X und =Y verschieden von =S.

Es kann zumindest einer oder zwei der Substituenten aus der Gruppe = X, = Y, = U, = V, = T, = W, = Z oder sämtliche Substituenten aus der Gruppe verschieden sein von = C(CN)₂.

Es kann zumindest ein oder beide Substituenten aus der Gruppe = X und = Y verschieden sein von = C(CN)₂.

Vorzugsweise ist zumindest einer oder beide Substituenten aus der Gruppe = X und = Y gleich = N(CN). Vorzugsweise ist alternativ oder zusätzlich einer oder beide Substituenten = V und = W gleich = N(CN) und/oder einer oder beide Substituenten = U und = T gleich = N(CN).

Vorzugsweise ist zumindest ein oder beide Substituenten aus der Gruppe = X und = Y und/oder ein oder beide Substituenten aus der Gruppe = V und = W gleich = N(NO2).

Vorzugsweise ist zumindest ein oder beide Substituenten aus der Gruppe = X und = Y und/oder ein oder beide Substituenten aus der Gruppe = V und = W gleich = NR, wobei R auch -CF3 oder allgemein Perfluoralkyl, insbesondere mit C1-C6, sein kann.

Vorzugsweise ist zumindest ein oder beide Substituenten aus der Gruppe = X und = Y und/oder ein oder beide Substituenten aus der Gruppe = V und = W gleich = N(C(O)R¹⁸.

Vorzugsweise ist zumindest ein oder beide Substituenten aus der Gruppe = X und = Y und/oder ein oder beide Substituenten aus der Gruppe = V und = W gleich = C(NO₂)₂.

Vorzugsweise ist zumindest ein oder beide Substituenten aus der Gruppe = X und = Y und/oder ein oder beide Substituenten aus der Gruppe = V und = W gleich = C(C(O)R¹³) (C(O)R¹⁴).

Vorzugsweise ist zumindest ein oder beide Substituenten aus der Gruppe = X und = Y und/oder ein oder beide Substituenten aus der Gruppe = V und = W gleich = C(CE₃)₂ oder allgemein = C(Perfluoraklyl)₂, insbesondere mit C1-6, sein.

Vorzugsweise sind zumindest ein oder zwei oder mehr oder sämtliche Substituenten aus der Gruppe = X, = Y, = U, = V, = T, = W, = Z gleich = N(CN).

Vorzugsweise sind zumindest ein oder zwei oder mehr oder sämtliche Substituenten aus der Gruppe = X, = Y, = U, = V, = T, = W, = Z gleich = C(NO₂)₂ oder enthalten eine mit dem chinoiden System konjugierte NO₂-Gruppe.

Vorzugsweise sind zumindest ein oder zwei oder mehr oder sämtliche Substituenten aus der Gruppe = X, = Y, = U, = V, = T, = W, = Z gleich = N(NO2).

Vorzugsweise sind zumindest ein oder zwei oder mehr oder sämtliche Substituenten aus der Gruppe = X, = Y, = U, = V, = T, = W, = Z gleich = NR, wobei R insbesondere auch -CF₃ oder Perfluoralkyl mit insbesondere C1-6, sein kann.

Vorzugsweise sind zumindest ein oder zwei oder mehr oder sämtliche Substituenten aus der Gruppe = X, = Y, = U, = V, = T, = W, = Z gleich =N(C(O)R¹⁸)_{.}

Vorzugsweise sind zumindest ein oder zwei oder mehr oder sämtliche Substituenten aus der Gruppe = X, = Y, = U, = V, = T, = W, = Z gleich = C(C(O)R¹³) (C(O)R¹⁴) oder enthalten eine mit dem chinoiden System konjugierte C(O)R-Gruppe.

Vorzugsweise ist zumindest ein oder zwei oder mehr oder sämtliche Substituenten aus der Gruppe = X, = Y, = U, = V, = T, = W, = Z gleich = C(CF₃)₂ oder allgemein = C(Perfluoralkyl)₂, insbesondere mit C1-6.

Insbesondere können für die Verbindungen 1-31 jeweils X = Y sein oder es können alle Substituenten X, Y, U, V, T, W, Z gleich sein, ohne hierauf beschränkt zu sein. Entsprechend können bei einer chinoiden Verbindung allgemein alle chinoide Substituenten gleich sein.

Gegebenenfalls sind X oder Y oder X und Y nicht gleich O, insbesondere für die Verbindungen oder 1 oder 20 oder für Verbindungen mit nur einem chinoiden Ring. Gegebenenfalls sind X oder Y oder X und Y nicht gleich S, insbesondere für die Verbindungen 1 oder 20. Gegebenenfalls sind X oder Y oder X und Y nicht gleich = C(CN)2, insbesondere für die Verbindungen 1 oder 20. Dies gilt insbesondere für eine Verbindung mit nur einem 6-gliedrigen chinoiden Ring, insbesondere für einen Ring mit 6 C-Atomen.

Weist die Verbindung zumindest eine oder zwei oder mehr chinoide =O-Gruppen und/oder =S-Gruppen auf, insbesondere wenn dies in einer der Verbindungen 1 bis 33 für T, U, V, W, X, Y oder Z gilt, besonders im Falle wenn X oder Y oder X und Y gleich O oder S ist, so ist der chinoide Ring, insbesondere wenn nur ein chinoider Ring vorliegt, vorzugsweise mit mindestens einem oder mindestens zwei Arylresten, von denen einer, mehrere oder sämtliche auch Heteroatome aufweisen können, anelliert oder substituiert.

Die Substituenten AA und/oder BB sind doppelbindige, mesomer und/oder induktiv elektronenziehende Substituenten, vorzugsweise ausgewählt aus der nachfolgend angegebenen Gruppe 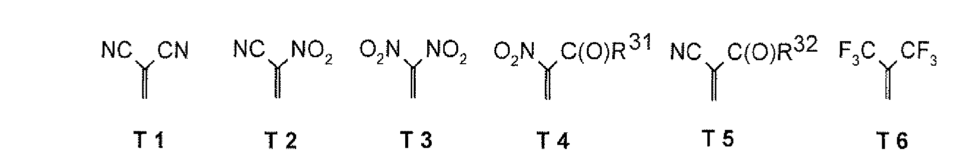 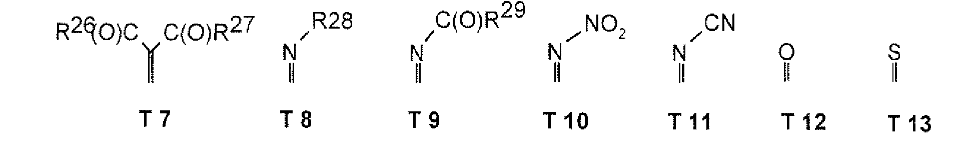 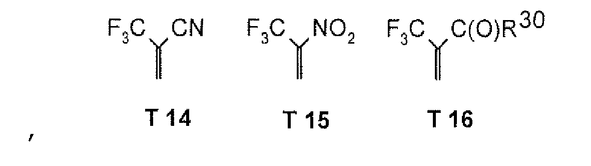 wobei gegebenenfalls auch andere geeignete zweibindige, insbesondere auch doppelbindige, Substituenten eingestzt werden können. R28 kann insbesondere auch -CF₃ oder eine andere Perfluoroalkylgruppe, vorzugsweise mit C1-6, sein.

Die erfindungsgemäße Verbindung kann ein chinoides System mit einem chinoiden Ring und 1, 2 oder 3 oder mehr anellierten und/oder jeweils einen Rest R bildenden aromatischen Ringen darstellen. Die aromatischen Ringe können jeweils ein oder mehrere Heteroatome aufweisen und substituiert oder unsubstituiert sein. Das chinoide System kann ein ortho- oder para-chinoides System sein. Das chinoide System kann insbesondere aus der Gruppe der Verbindungen 1-33 ausgewählt sein, ohne hierauf beschränkt zu sein. Ein, zwei, drei oder mehr oder sämtliche der aromatischen Ringe können auch durch eine Gruppe -M1-C(R)=C(R)-M2- oder -M1-C(=Z)-M2- mit M1, M2 gleich und/oder ungleich und ausgewählt aus der Gruppe -O-, -S-, -NRsein.

Die Erfindung umfasst ferner Verbindungen mit einem chinoiden System aus zwei Ringen aus jeweils 5 oder 6 Ringatomen, die mit 1,2,3,4,5 oder 6 oder mehr aromatischen Ringen anelliert und/oder unter Bildung eines Restes R substituiert sein können. Die aromatischen Ringe können substituiert oder unsubstituiert sein.

Die Ringe weisen vorzugsweise jeweils 6 Atome, die 6 Kohlenstoffatome sein können, auf. In einem oder mehreren Ringen oder je Verbindung insgesamt können 1, 2, 3 oder 4 oder mehr C-Atome durch Heteroatome wie O, S, N ersetzt sein. Verschiedene chinoide Systeme können anelliert, durch eine oder mehrere Doppel- oder Dreifachbindungen, die C-C-Bindung oder Heteroatom-C-Bindungen sein können, mesomer verbunden oder anderweitig verknüpft sein. Die Verbindung kann insbesondere ausgewählt sein aus der Gruppe der Verbindungen 1-33, ohne hierauf beschränkt zu sein. Ein, zwei, drei oder mehr oder sämtliche der aromatischen Ringe können auch durch eine Gruppe -M1-C(R)=C(R)-M2- oder -M1-C(=Z)-M2- mit M1, M2 gleich und/oder ungleich und ausgewählt aus der Gruppe -O-, -S-, -NR- sein.

Ferner betrifft die Erfindung Verbindungen mit 3 oder 4 chinoiden Ringen aus jeweils unabhängig voneinander 5 oder 6 Atomen, die 1,2,3,4,5,6,7,8,9 oder 10 anellierte oder einen Rest R bildenden aromatische Ringe mit 6 Atomen aufweisen können. Die aromatischen Ringe können substituiert oder unsubstituiert sein. Von den Kohlenstoffatomen eines Ringes, mehrerer Ringe oder der Verbindung insgesamt können 1,2,3 oder 4 Atome Heteroatome wie O, N oder P sind. Die Verbindung kann insbesondere ausgewählt sein aus der Gruppe der Verbindungen 1-33, ohne hierauf beschränkt zu sein. Ein, zwei, drei oder mehr oder sämtliche der aromatischen Ringe können auch durch eine Gruppe -M1-C(R)=C(R)-M2- oder -M1-C(=Z)-M2- mit M1, M2 gleich und/oder ungleich und ausgewählt aus der Gruppe -O-, -S-, -NRsein.

Unabhängig hiervon können die erfindungsgemäß verwendeten Verbindungen 1,2,3,4,5,6,7,8,9 oder 10 Arylreste aufweisen, von denen vorzugsweise zumindest einer, mehrere oder besonders bevorzugt sämtliche mit einem oder mehreren chinoiden Systemen und/oder untereinander anelliert sind und/oder die Reste R bilden. Die aromatischen Ringe können substituiert oder unsubstituiert sein. Unter Arylresten seien hier auch Heteroarylreste verstanden. Die Arylreste können jeweils zwei chinoide Ringe miteinander verknüpfen, vorzugsweise unter mesomerer Verknüpfung der chinoiden Ringe. Das chinoide System kann insbesondere aus der Gruppe der Verbindungen 1-33 ausgewählt sein, ohne hierauf beschränkt zu sein. Ein, zwei, drei oder mehr oder sämtliche der aromatischen Ringe können auch durch eine Gruppe -M1-C(R)=C(R)-M2- oder "M1-C(=Z)-M2- mit M1, M2 gleich und/oder ungleich und ausgewählt aus der Gruppe -O-, - S-, -NR- sein. So können beispielsweise in den Verbindungen 4, 22 oder 23 jeweils 2 oder 3 oder mehr (Hetero)arylringe zwischen den chinoiden Ringen, diese verbrückend, angeordnet sein.

Die aromatischen Ringe der genannten chinoiden Systeme und/oder die Gruppen -M1-C(R)=C(R)-M2- oder -M1-C(= Z)-M2-sind vorzugsweise perhalogeniert, insbesondere perfluoriert oder percyanosubstituiert. Vorzugsweise sind keine weiteren nicht-aromatischen und/oder nicht-chinoiden Ringe enthalten.

Unabhängig hiervon können die erfindungsgemäß verwendeten Verbindungen 2,3,4,5 oder 6 oder mehr chinoide Ringsysteme aufweisen. Vorzugsweise sind einer, mehrere oder sämtliche der chinoiden Ringe 5- oder 6-gliedrig. Ringkohlenstoffatome können durch Heteroatome ersetzt sein. Zumindest zwei, mehrere oder sämtliche der chinoiden Ringe können miteinander unter mesomerer Verknüpfung zu einem größeren chinoiden System anelliert oder durch eine oder mehrere Brücken miteinander mesomer verknüpft oder nicht unter Bildung eines größeren mesomeren Systems verknüpft sein. Die Verbindung kann insbesondere ausgewählt sein aus der Gruppe der Verbindungen 1-33, ohne hierauf beschränkt zu sein. Das chinoide System kann insbesondere aus der Gruppe der Verbindungen 1-33 ausgewählt sein, ohne hierauf beschränkt zu sein. Ein, zwei, drei oder mehr oder sämtliche der aromatischen Ringe können auch durch eine Gruppe -M1-C(R)=C(R)-M2- oder -M1-C(=Z)-M2- mit M1, M2 gleich und/oder ungleich und ausgewählt aus der Gruppe -O-, -S-, -NRsein.

Die Substituenten A, B, K, D, E, F, G; H der Verbindungen 14 und 15 können unterschiedlich oder auch gleich sein und folgende Strukturen annehmen, Imin-Stickstoff =N- , Phosphin =P-oder substituierten Methylenkohlenstoff =C-R¹⁻⁸.

Es versteht sich, dass in allen erfindungsmäßen Verbindungen ein, mehrere oder sämtliche N-Atome jeweils durch P-Atome ersetzt sein können.

Insbesondere können folgende Verbindungen mit folgenden Substitutionsmustern erfindungsgemäß verwendet werden:

Die Verbindungen 1, 2, 3(m=0), 3(m=1), 3(m=3), 3(m=4), 3b(m=1), 3b(m=2), 3b(m=3), 3b(m=4), 3c(m=1), 3c(m=2), 3c(m=3), 3c(m=4), 6, 7, 10, 11, 11a, 14, 15, 16, 17, 18, 19, 20, 21 (für M ungleich =C=Z), 26 (für M ungleich =C=Z), 27 (für M gleich -O-, -S-, -NR- oder =C=Z mit Z = S1, S2, S3, S4, S5, S6, S7, S8, S9, S10, S11, S12, S13, S14, S15, S16, S17, S18, S19, S20 oder S21), 28 (für U = S1, S2, S3, S4, S5, S6, S7, S8, S9, S10, S11, S12, S13, S14, S15, S16, S17, S18, S19, S20 oder S21), 30 (mit M gleich -O-, -S-, -NR- oder =C=T mit T = S1, S2, S3, S4, S5, S6, S7, S8, S9, S10, S11, S12, S13, S14, S15, S16, S17, S18, S19, S20 oder S21), 32, 33

weisen insbesondere jeweils folgende konkrete Substitutionsmuster auf, wobei jeder einzelnen der Verbindungen nachfolgend der Substituent X einer ersten Zeile und der darunterstehende Substituent Y der nachfolgenden Zeile zugeordnet ist

mit jeweils X und Y wie folgt:
X: S1, S1, S1, S1, S1, S1, S1, S1, S1, S1, S1, S1, S1, S1,
Y: S1, S2, S3, S4, S5, S6, S7, S8, S9, S10, S11, S12, S13, S14,
X: S1, S1, S1, S1, S1, S1, S1
Y: S15, S16, S17, S18, S19, S20, S21

oder mit jeweils X und Y wie folgt:
X: S2, S2, S2, S2, S2, S2, S2, S2, S2, S2, S2, S2, S2, S2,
Y: S1, S2, S3, S4, S5, S6, S7, S8, S9, S10, S11, S12, S13, S14,
X: S2, S2, S2, S2, S2, S2, S2
Y: S15, S16, S17, S18, S19, S20, S21

oder mit jeweils X und Y wie folgt:
X: S3, S3, S3, S3, S3, S3, S3, S3, S3, S3, S3, S3, S3, S3,
Y: S1, S2, S3, S4, S5, S6, S7, S8, S9, S10, S11, S12, S13, S14,
X: S3, S3, S3, S3, S3, S3, S3
Y: S15, S16, S17, S18, S19, S20, S21

oder mit jeweils X und Y wie folgt:
X: S4, S4, S4, S4, S4, S4, S4, S4, S4, S4, S4, S4, S4, S4,
Y: S1, S2, S3, S4, S5, S6, S7, S8, S9, S10, S11, S12, S13, S14,
X: S4, S4, S4, S4, S4, S4, S4
Y: S15, S16, S17, S18, S19, S20, S21

oder mit jeweils X und Y wie folgt:
X: S5, S5, S5, S5, S5, S5, S5, S5, S5, S5, S5, S5, S5, S5,
Y: S1, S2, S3, S4, S5, S6, S7, S8, S9, S10, S11, S12, S13, S14,
X: S5, S5, S5, S5, S5, S5, S5
Y: S15, S16, S17, S18, S19, S20, S21

oder mit jeweils X und Y wie folgt:
X: S6, S6, S6, S6, S6, S6, S6, S6, S6, S6, S6, S6, S6, S6,
Y: S1, S2, S3, S4, S5, S6, S7, S8, S9, S10, S11, S12, S13, S14,
X: S6, S6, S6, S6, S6, S6, S6
Y: S15, S16, S17, S18, S19, S20, S21

oder mit jeweils X und Y wie folgt:
X: S7, S7, S7, S7, S7, S7, S7, S7, S7, S7, S7, S7, S7, S7,
Y: S1, S2, S3, S4, S5, S6, S7, S8, S9, S10, S11, S12, S13, S14,
X: S7, S7, S7, S7, S7, S7, S7
Y: S15, S16, S17, S18, S19, S20, S21

oder mit jeweils X und Y wie folgt:
X: S8, S8, S8, S8, S8, S8, S8, S8, S8, S8, S8, S8, S8, S8,
Y: S1, S2, S3, S4, S5, S6, S7, S8, S9, S10, S11, S12, S13, S14,
X: S8, S8, S8, S8, S8, S8, S8
Y: S15, S16, S17, S18, S19, S20, S21

oder mit jeweils X und Y wie folgt:
X: S9, S9, S9, S9, S9, S9, S9, S9, S9, S9, S9, S9, S9, S9,
Y: S1, S2, S3, S4, S5, S6, S7, S8, S9, S10, S11, S12, S13, S14,
X: S9, S9, S9, S9, S9, S9, S9
Y: S15, S16, S17, S18, S19, S20, S21

oder mit jeweils X und Y wie folgt:
X: S10, S10, S10, S10, S10, S10, S10, S10, S10, S10, S10, S10,
Y: S1, S2, S3, S4, S5, S6, S7, S8, S9, S10, S11, S12, X: S10, S10, S10, S10, S10, S10, S10, S10, S10 Y: S13, S14, S15, S16, S17, S18, S19, S20, S21

oder mit jeweils X und Y wie folgt:
X: S11, S11, S11, S11, S11, S11, S11, S11, S11, S11, S11, S11, Y: S1, S2, S3, S4, S5, S6, S7, S8, S9, S10, S11, S12, X: S11, S11, S11, S11, S11, S11, S11, S11
Y: S13, S14, S15, S16, S17, S18, S19, S20, S21

oder mit jeweils X und Y wie folgt:
X: S12, S12, S12, S12, S12, S12, S12, S12, S12, S12, S12, S12, Y: S1, S2, S3, S4, S5, S6, S7, S8, S9, S10, S11, S12, X: S12, S12, S12, S12, S12, S12, S12, S12
Y: S13, S14, S15, S16, S17, S18, S19, S20, S21

oder mit jeweils X und Y wie folgt:
X: S13, S13, S13, S13, S13, S13, S13, S13, S13, S13, S13, S13, Y: S1, S2, S3, S4, S5, S6, S7, S8, S9, S10, S11, S12, X: S13, S13, S13, S13, S13, S13, S13, S13
Y: S13, S14, S15, S16, S17, S18, S19, S20, S21

oder mit jeweils X und Y wie folgt:
X: S14, S14, S14, S14, S14, S14, S14, S14, 514, S14, S14, S14, Y: S1, S2, S3, S4, S5, S6, S7, S8, S9, S10, S11, S12, X: S14, S14, S14, S14, S14, S14, S14, S14
Y: S13, S14, S15, S16, S17, S18, S19, S20, S21

oder mit jeweils X und Y wie folgt:
X: S15, S15, S15, S15, S15, S15, S15, S15, S15, S15, S15, S15, Y: S1, S2, S3, S4, S5, S6, S7, S8, S9, S10, S11, S12, X: S15, S15, S15, S15, S15, S15, S15, S15
Y: S13, S14, S15, S16, S17, S18, S19, S20, S21

oder mit jeweils X und Y wie folgt:
X: S16, S16, S16, S16, S16, S16, S16, S16, S16, S16, S16, S16, Y: S1, S2, S3, S4, S5, S6, S7, S8, S9, S10, S11, S12, X: S16, S16, S16, S16, S16, S16, S16, S16
Y: S13, S14, S15, S16, S17, S18, S19, S20, S21

oder mit jeweils X und Y wie folgt:
X: S17, S17, S17, S17, S17, S17, S17, S17, S17, S17, S17, S17, Y: S1, S2, S3, S4, S5, S6, S7, S8, S9, S10, S11, S12, X: S17, S17, S17, S17, S17, S17, S17, S17
Y: S13, S14, S15, S16, S17, S18, S19, S20, S21

oder mit jeweils X und Y wie folgt:
X: S18, S18, S18, S18, S18, S18, S18, S18, S18, S18, S18, S18, Y: S1, S2, S3, S4, S5, S6, S7, S8, S9, S10, S11, S12, X: S18, S18, S18, S18, S18, S18, S18, S18
Y: S13, S14, S15, S16, S17, S18, S19, S2Q, S21

oder mit jeweils X und Y wie folgt:
X: S19, S19, S19, S19, S19, S19, S19, S19, S19, S19, S19, S19, Y: S1, S2, S3, S4, S5, S6, S7, S8, S9, S10, S11, S12, X: S19, S19, S19, S19, S19, S19, S19, S19, S19
Y: S13, S14, S15, S16, S17, S18, S19, 820, S21

oder mit jeweils X und Y wie folgt:
X: S20, S20, S20, S20, S20, S20, S20, S20, S20, S20, S20, S20, Y: S1, S2, S3, S4, S5, S6, S7, S8, S9, S10, S11, S12, X: S20, 520, S20, S20, S20, S20, S20, S20, S21
Y: S13, S14, S15, S16, S17, S18, S19, S20, S21

oder mit jeweils X und Y wie folgt:
X: S21, S21, S21, S21, S21, S21, S21, S21, S21, S21, S21, S21, Y: S1, S2, S3, S4, S5, S6, S7, S8, S9, S10, S11, S12, X: S21, S21, S21, S21, S21, S21, S21, S21, S21
Y: S13, S14, S15, S16, S17, S18, S19, S20, S21.

Die Verbindungen 4, 5, 5b, 5c, 8, 9, 12, 21 (wobei 2 Reste M gleich V und W sind), 22, 23, 24, 24a, 24b, 25 und 26 (für M ungleich =C=Z), 27 (für M ungleich =C=Z), 29, 31

weisen insbesondere jeweils folgende konkrete Substitutionsmuster auf, wobei jeder einzelnen der Verbindungen nachfolgend der Substituent X einer ersten Zeile und der darunterstehende Substituent V, wie jeweils am Zeilenbeginn angegeben, der nachfolgenden Zeile zugeordnet ist
mit X=Y und V=W

und mit X und V wie folgt:
X: S1, S1, S1, S1, S1, S1, S1, S1, S1, S1, S1, S1, S1, S1,
V: S1, S2, S3, S4, S5, S6, S7, S8, S9, S10, S11, S12, S13, S14,
X: S1, S1, S1, S1, S1, S1, S1
V: S15, S16, S17, S18, S19, S20, S21.

oder mit X und V wie folgt:
X: S2, S2, S2, S2, S2, S2, S2, S2, S2, S2, S2, S2, S2, S2,
V: S1, S2, S3, S4, S5, S6, S7, S8, S9, S10, S11, S12, S13, S14,
X: S2, S2, S2, S2, S2, S2, S2
V: S15, S16, S17, S18, S19, S20, S21

oder mit X und V wie folgt:
X: S3, S3, S3, S3, S3, S3, S3, S3, S3, S3, S3, S3, S3, S3,
V: S1, S2, S3, S4, S5, S6, S7, S8, S9, S10, S11, S12, S13, S14,
X. S3, S3, S3, S3, S3, S3, S3
V: S15, S16, S17, S18, S19, S20, S21.

oder mit X und V wie folgt:
X: S4, S4, S4, S4, S4, S4, S4, S4, S4, S4, S4, S4, S4, S4,
V: S1, S2, S3, S4, S5, S6, S7, S8, S9, S10, S11, S12, S13, S14,
X: S4, S4, S4, S4, S4, S4, S4
V: S15, S16, S17, S18, S19, S20, S21

oder mit X und V wie folgt:
X: S5, S5, S5, S5, S5, S5, S5, S5, S5, S5, S5, S5, S5, S5,
V: S1, S2, S3, S4, S5, S6, S7, S8, S9, S10, S11, S12, S13, S14,
X: S5, S5, S5, S5, S5, S5, S5
V: S15, S16, S17, S18, S19, S20, S21

oder mit X und V wie folgt:
X: S6, S6, S6, S6, S6, S6, S6, S6, S6, S6, S6, S6, S6, S6,
V: S1, S2, S3, S4, S5, S6, S7, S8, S9, S10, S11, S12, S13, S14,
X: S6, S6, S6, S6, S6, S6, S6
V: S15, S16, S17, S18, S19, S20, S21

oder mit X und V wie folgt:
X: S7, S7, S7, S7, S7, S7, S7, S7, S7, S7, S7, S7, S7, S7,
V: S1, S2, S3, S4, S5, S6, S7, S8, S9, S10, S11, S12, S13, S14,
X: S7, S7, S7, S7, S7, S7, S7
V: S15, S16, S17, S18, S19, S20, S21

oder mit X und V wie folgt:
X: S8, S8, S8, S8, S8, S8, S8, S8, S8, S8, S8, S8, S8, S8,
V: S1, S2, S3, S4, S5, S6, S7, S8, S9, S10, S11, S12, S13, S14,
X: S8, S8, S8, S8, S8, S8, S8
V: S15, S16, S17, S18, S19, S20, S21

oder mit X und V wie folgt:
X: S9, S9, S9, S9, S9, S9, S9, S9, S9, S9, S9, S9, S9, S9,
V: S1, S2, S3, S4, S5, S6, S7, S8, S9, S10, S11, S12, S13, S14,
X: S9, S9, S9, S9, S9, S9, S9
V: S15, S16, S17, S18, S19, S20, S21

oder mit X und V wie folgt:
X: S10, S10, S10, S10, S10, S10, S10, S10, S10, S10, S10, S10,
V: S1, S2, S3, S4, S5, S6, S7, S8, S9, S10, S11, S12, X: S10, S10, S10, S10, S10, S10, S10, S10, S10
V: S13, S14, S15, S16, S17, S18, S19, S20, S21

oder mit X und V wie folgt:
X: S11, S11, S11, S11, S11, S11, S11, S11, S11, S11, S11, S11, V: S1, S2, S3, S4, S5, S6, S7, S8, S9, S10, S11, S12, X: S11, S11, S11, S11, S11, S11, S11, S11
V: S13, S14, S15, S16, S17, S18, S19, S20, S21

oder mit X und V wie folgt:
X: S12, S12, S12, S12, S12, S12, S12, S12, S12, S12, S12, S12, V: S1, S2, S3, S4, S5, S6, S7, S8, S9, S10, S11, S12, X: S12, S12, S12, S12, S12, S12, S12, S12
V: S13, S14, S15, S16, S17, S18, S19, S20, S21

oder mit X und V wie folgt:
X: S13, S13, S13, S13, S13, S13, S13, S13, S13, S13, S13, S13, V: S1, S2, S3, S4, S5, S6, S7, S8, S9, S10, S11, S12, X: S13, S13, S13, S13, S13, S13, S13, S13
V: S13, S14, S15, S16, S17, S18, S19, S20, S21

oder mit X und V wie folgt:
X: S14, S14, S14, S14, S14, S14, S14, S14, S14, S14, S14, S14, V: S1, S2, S3, S4, S5, S6, S7, S8, S9, S10, 811, S12, X: S14, S14, S14, S14, S14, S14, S14, S14
V: S13, S14, S15, S16, S17, S18, S19, S20, S21

oder mit X und V wie folgt:
X: S15, S15, S15, S15, S5, S15, S15, S15, S15, S15, S15, S15, V: S1, S2, S3, S4, S5, S6, S7, S8, S9, S10, S11, S12, X: S15, S15, S15, S15, S15, S15, S15, S15
V: S13, S14, S15, S16, S17, S18, S19, S20, S21

oder mit X und V wie folgt:
X: S16, S16, S16, S16, S16, S16, S16, S16, S16, S16, S16, S16, V: S1, S2, S3, S4, S5, S6, S7, S8, S9, 310, S11, S12, X: S16, S16, S16, S16, S16, S16, S16, S16
V: S13, S14, S15, S16, S17, S18, S19, S20, S21

oder mit X und V wie folgt:
X: S17, S17, S17, S17, S17, S17, S17, S17, S17, S17, S17, S17, V: S1, S2, S3, S4, S5, S6, S7, S8, S9, S10, S11, S12, X: S17, S17, S17, S17, S17, S17, S17, S17
V: S13, S14, S15, S16, S17, S18, S19, S20, S21

oder mit X und V wie folgt:
X: S18, S18, S18, S18, S18, S18, S18, S18, S18, S18, S18, S18, V: S1, S2, S3, S4, S5, S6, S7, S8, S9, S10, S11, S12, X: S18, S18, S18, S18, S18, S18, S18, S18
V: S13, S14, S15, S16, S17, S18, S19, S20, S21

oder mit X und V wie folgt:
X: S19, S19, S19, S19, S19, S19, S19, S19, S19, S19, S19, S19, V: S1, S2, S3, S4, S5, S6, S7, S8, S9, S10, S11, S12, X: S19, S19, S19, S19, S19, S19, S19, S19, S19
V: S13, S14, S15, S16, S17, S18, S19, S20, S21

oder mit X und V wie folgt:
X: S20, S20, S20, S20, S20, S20, S20, S20, S20, S20, S20, S20, V: S1, S2, S3, S4, S5, S6, S7, S8, S9, S10, S11, S12, X: S20, S20, S20, S20, S20, S20, S20, S20, S21
V: S13, S14, 815, S16, S17, S18, S19, S20, S21

oder mit X und V wie folgt:
X: S21, S21, S21, S21, S21, S21, S21, S21, S21, S21, S21, S21, V: S1, S2, S3, S4, S5, S6, S7, S8, S9, S10, S11, S12, X: S21, S21, S21, S21, S21, S21, S21, S21, S21
V: S13, S14, S15, S16, S17, S18, S19, S20, S21.

Die Erfindung umfasst ferner die genannten Verbindungen 4, 5, 5b, 5c, 8, 9, 12, 21 (wobei 2 Reste M gleich V und W sind), 22, 23, 24, 24a, 24b, 25 und 26 (für M ungleich =C=Z), 27 (für M ungleich =C=Z), 29, 31 wenn für die Substituenten gilt X = V und Y = W mit den konkreten Substitutionsmustern, wenn in den oben genannten Tabellen für diese Verbindungen V durch Y ersetzt wird und wenn jeder einzelnen der Verbindungen nachfolgend der Substituent X einer ersten Zeile und der darunterstehende Substituent Y der nachfolgenden Zeile zugeordnet ist.

Die Erfindung umfasst ferner die genannten Verbindungen 4, 5, 5b, 5c, 8, 9, 12, 21 (wobei 2 Reste M gleich V und W sind), 22, 23, 24, 24a, 24b, 25 und 26 (für M ungleich =C=Z), 27 (für M ungleich =C=Z), 29, 31 wenn für die Substituenten gilt X = W und Y = V mit den konkreten Substitutionsmustern, wenn jeder einzelnen der Verbindungen nachfolgend der Substituent X einer ersten Zeile und der darunterstehende Substituent Y der nachfolgenden Zeile zugeordnet ist.

In den Verbindungen 21, 25 und 26 können hierbei beide Reste gleich oder unabhängig voneinander sein: -S-, -O-, -NR- oder =C =Z mit Z=S1, S2, S3, S4, S5, S6, S7, S8, S9, S10, S11, S12, S13, S14, S15, S16, S17, S18, S19, S20 oder S21.

Die Reste R¹ bis R³² können gleich oder verschieden und ausgewählt sein aus der Gruppe bestehend aus Wasserstoff, Halogen, (insbesondere -F, -Cl), Cyano, Nitro, Nitroso, Sulfamid (unsubstituiert oder substituiert, insbesondere C1-C6 mono oder di-Alkyl substituiert), Carboxy, C1-C7 Carbalkoxy, C1-C7 Sulfo, Sulfohalogen (insbesondere -F oder -Cl), Halogencarbonyl (insbesondere F oder -Cl), Carbamoyl (unsubstituiert oder substituiert, insbesondere C1-C6 N monosubstituiert oder gleich oder unabhängig voneinander N-C1-C6 disubstituiert), Formyl, Amidinformyl, C1-C6 Alkylsulfanyl, C1-C6 Alkylsulfonyl, C1-C25 Kohlenwasserstoff, vorzugsweise C1-C14 Kohlenwasserstoff oder C1 bis C10 oder C1 bis 6 Kohlenwasserstoff, wobei eines oder mehrere oder sämtliche der Kohlenstoffatome der Gruppe mit einem oder mehreren oben genannten Resten substituiert sein kann, wobei der Kohlenwasserstoff gesättigt, ungestättigt oder ein aromatischer Kohlenwasserstoff sein kann. Die Kohlengasserstoffgruppen können jeweils insbesondere perhalogeniert, perchloriert oder perfluoriert (insbesondere Trifluormethyl) sein. Die Kohlenwasserstoffgruppen können linear oder verzweigt oder cyclisch sein, beispielsweise Cyclohexyl oder Cyclopentyl. Ein oder mehrere Kohlenstoffatome können jeweils durch Heteroatome, insbesondere N, O, S, -(O)S(O)- oder P(R) ersetzt sein. Die (Hetero)kohlenwasserstoffreste können untereinander oder mit einem chinoide oder anderem Ring, beispeilsweise einem (Hetero)arylriner cyclisch verknüpft sein.

Insbesondere können die Reste R¹ bis R³² eine der Gruppen Acetyl-, Trifluoracetyl-, Benzoyl-, Pentafluarbenzoyl-, Naphthoyl- oder Alkoxycarbonyl, wobei der Alkylrest ein Alkyl mit einem bis sechs oder bis zehn, insbesondere bis vier, unverzweigt oder verzweigt miteinander verbundenen C-Atomen sein kann, sowie Trialkylphosphoryl mit Alkylresten, die ebenfalls aus einer Kette mit bis zu fünf oder sechs oder acht unverzweigt oder verzweigt oder cyclisch miteinander verknüpften Kohlenstoffatomen bestehen können, oder Triarylphosphoryl mit Arylresten mit vorzugsweise 6 bis 14 C-Atomen, insbesondere bis 10 C-Atomen.

Weiterhin können die Reste R¹ - R³², die gleich oder untereinander verschieden sein können, entweder Aryl oder Heteroaryl, wie z.B. Phenyl, Naphthyl, Anthranyl, Pyridyl, Chinoxalyl, Pyrazolyl, Oxazolyl, 1,3,2-Dioxaborinyl oder 1,3,4 Oxdiazolyl sein, die entweder durch Wasserstoff oder ein niederes Alkyl mit einem bis acht gesättigten Kohlenstoffatomen, die unverzweigt oder verzweigt oder cyclisch miteinander verbunden sein können, vorzugsweise jedoch durch Halogen, dabei vor allen Fluor oder Chlor, Trichlormethyl, Perfluoralkyl mit einem bis zu sechs Kohlenstoffatomen, dabei insbesonders Trifluormethyl, aber auch durch Cyano, Nitro, Nitrose, Sulfo, Carboxy, Carbalkoxy, Halogencarbonyl, Carbamoyl, Formyl, Amidinformyl, Alkylsulfanyl und Alkylsulfonyl, wobei die Alkylreste hier wiederum aus einer Kette mit bis zu fünf oder sechs oder bis zu acht unverzweigt oder verzweigt oder cyclisch miteinander verknüpftten Kohlenstoffatomen bestehen können, sowie durch Trialkylphosphoryl mit Alkylresten, die ebenfalls aus einer Kette mit bis zu fünf oder sechs oder bis zu acht unverzweigt oder verzweigt miteinander verknüpften Kohlenstoffatomen bestehen können, substituiert sein. Insbesondere können die Aryl- oder Heteroarylreste perhalogeniert, insbesondere perfluoriert sein.

Die Reste R², R³, R⁴, R⁵, R⁶ in den Verbindungen 3, 3b, 3c oder Formeln IV, V oder VI können für verschiedene n oder m gleich oder unterschiedlich sein.

Die Reste R¹ bis R³², die mit einem chinoiden oder aromatischen System einer erfindungsgemäß verwendeten Verbindung verbunden und zueinander benachbart angeordnet und durch zwei, drei oder vier Atome der chinoiden oder aromatischen Gerüststruktur getrennt sind, können miteinander unter Ausbildung eines carbocyclischen, insbesondere aromatischen Ringes, oder heterocyclischen, insbesondere heterocarbocyclischen Ringes verbunden sein. Dies gilt insbesondere für die Verbindungen 1 bis 33, aber auch für andere erfindungsgemäß verwendete Chinone oder Chinonderivate. Dies gilt beispielsweise jeweils paarweise alternativ oder gleichzeitig für die Reste R1, R2 und/oder R3, R4 der Verbindungen 1, 3, 3b, 7, 8, 9, 10, 11, 12, 23, 24, 25, 27, 28, die Reste R1, R2; R2, R3; R4, R5 und/oder R5, R6 der Verbindung 2, die Reste R1, R2; R3, R4; R5, R6; R7, R8 der Verbindung 3, die Reste R5, R6; R7, R8 der Verbindungen 28, 29 oder andere. Die überbrückende Atomgruppe kann insbesondere eine Gruppe bilden, die ausgewählt ist aus
-L¹-C(R¹) = C(R²)-L²- mit L=O, S, NR oder CR¹⁴R¹⁵,
oder -C(X)C(Y)-C(R¹) = C(R²)-
oder -C(= X)C(R³)= C(R⁴)-C(= Y)-
oder -C (= X)-L-C(= Y)- mit L=O, S, NR, CR¹⁴R¹⁵
mit X und Y wie oben definiert und vorzugsweise ausgewählt aus der Gruppe 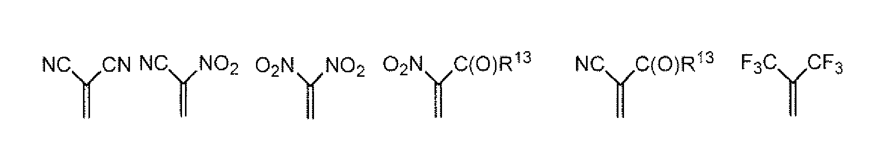 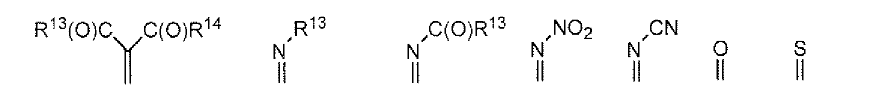 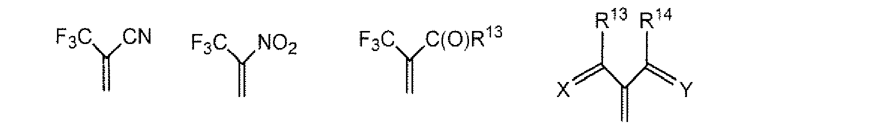 wobei die Reste R13 der verschiedenen Gruppen verschieden sein können. Die angegebenen überbrückenden Atomgruppen können insbesondere vorgesehen sein, wenn X und/oder Y gleich =O oder =S oder =C(CN)₂ ist. Insbesondere kann dann L gleich -O- oder -S- oder -NR- sein.

Je zwei benachbarte Reste von **R¹** - **R³²** können aber auch über eine Carboxy- -(CO)- oder eine Carbimidgruppe -(CNR)- , wobei für dieses **R** das analoge Substitutionsmuster wie für **R¹** - **R³⁰** gilt, miteinander verbunden sein. Es ist aber auch möglich, das zwei benachbarte Reste **R** so über Kohlenstoffatome oder Heteroatome miteinander verknüpft sind, dass ein neues carbocyclisches oder heterocyclisches Strukturelement an das jeweilige cyclische Grundgerüst ankondensiert ist. Beispielsweise können im Verbindungstyp **1** die Reste **R¹** und **R²** sowie auch **R³** und **R⁴** für einen ankondensierten Benzo- oder Naphthorest, aber auch für einen ankondensierten Thiophen-, Furan-, 1,3,4-Oxdiazol-, Pyridin-, Pyrazin-, Triazin-, Tetrazin-, Pyran-, Thiopyran-, Dithiin-, Phosphorin-, Phthalsäureanhydrid, Phthalsäureimid bzw. Dithiazol-Rest stehen, wobei diese Reste wieder ausschließlich oder teilweise durch weitere elektronenziehende Gruppierungen, wie Halogen, darunter vorzugsweise Fluor oder Chlor, Trifluormethyl oder Cyan, Nitro, Nitroso, Sulfo, Carboxy, Carbalkoxy, Halogencarbonyl, Carbamoyl, Formyl, Amidinformyl substituiert sein können. Analoges gilt für die Reste R¹ und R² bzw. R² und R³ oder für die Reste R⁴ und R⁵ bzw. R⁵ und R⁶ im Verbindungstyp **2** sowie für die Reste R¹ und R², R³ und R⁴, R⁵ und R⁶ sowie R⁷ und R⁸ im Verbindungstyp **3,** sowie für die Reste R² und R³ bzw. R⁵ und R⁶ im Verbindungstyp **4** bzw. **5,** sowie für die entsprechenden Paare der Reste R der anderen Verbindungen, die einander ausreichend nahe kommen, um einen 5- oder 6-gliedrigen Ring zu bilden.

Die verbrückte Trans-Diketororm von Verbindung **8** kann z.B. zu den Strukturen **28** oder **29** führen. In der Formel **26** kann der Carbonsäureanhydrid-Sauerstoff auch durch eine substituierte Stickstoffgruppe =N-R¹ ersetzt werden und damit eine Carbonsäureimidstruktur ausbilden.

Die aromatischen Reste, mit denen die chinoiden Systeme substituiert und/oder anelliert sein können, können perhalogeniert sein, insbesondere perfluoriert, perchloriert oder perfluorochloriert. Gegebenenfalls können einige, beispielsweise bis zur Hälfte oder mehr der Halogenatome durch Wasserstoff ersetzt sein. Entsprechendes kann auch alternativ oder gleichzeitig für die Reste R der chinoiden Systeme gelten. Anstelle der Halogenatome können an den aromatischen Resten und/oder den chinoiden Systemen auch CN-Gruppen vorgesehen sein.

Jeweils zwei chinoide Systeme Ch1 und Ch2 können unter Bildung einer Verbindung Ch1-ZB-Ch2 über einen Rest **ZB** miteinander verknüpft sein, wobei die chinoiden Reste Ch1 und Ch2 mesomer miteinander verknüpft sein können oder mesomer voneinander unabhängig sein können. Die chinoiden Reste Ch1 und Ch2 können gleich oder verschieden sein und können ausgewählt sein aus der Gruppe der Verbindungen 1 bis 4 und 5 bis 33, wobei gegebenenfalls auch weitere chinoide Systeme miteinander verknüpft sein können, beispielsweise unter Ausbildungen von Strukturen wie Ch1-ZB1-Ch2-ZB2-Ch3, wobei Ch1, Ch2, Ch3 gleich oder verschieden sein können und jeweils die Verbindungen 1 bis 4 und 5 bis 33 darstellen können, ohne hierauf beschränkt zu sein. ZB1 und ZB2 können gleich oder verschieden sein.

Die Brücke -Z- kann 1, 2 bis 4, bis 6 oder bis 10 oder auch mehr Brückenatome aufweisen, die Kohlenstoffatome oder zumindest teilweise Heteroatome sein können.

Wenn zwei chinoide Verbindungen, wie in Formel 5, 5b oder 5c, über einen Rest **Z** miteinander verknüpft sind, kann diese Brücke -Z- aus Alkenylen, Halogenalkenylen, Acetylen, Alkylen, Halogenalkylen, insbesondere Perfluoralkylen mit einem bis acht gesättigten Kohlenstoffatomen, die unverzweigt oder verzweigt miteinander verbunden sein können, oder aus Arylen, Hetarylen, die entweder mit Wasserstoff oder mit niederen Alkylresten mit einem bis sechs oder bis acht gesättigten Kohlenstoffatomen, die unverzweigt oder verzweigt oder cyclisch miteinander verbunden sein können, vorzugsweise jedoch mit Halogen, dabei vor allen Fluor oder Chlor, Trichlormethyl, Perfluoralkyl mit einem bis zu sechs Kohlenstoffatomen, dabei insbesonders Trifluormethyl, aber auch Cyano, Nitro, Nitroso, Sulfo, Carboxy, Carbalkoxy, Halogencarbonyl, Carbamoyl, Formyl, Amidinformyl, Alkylsulfanyl und Alkylsulfonyl, wobei die Alkylreste hier wiederum aus einer Kette mit bis zu acht unverzweigt oder verzweigt oder cyclisch miteinander verbundenen Kohlenstoffatomen bestehen können, sowie Trialkylphosphoryl mit Alkylresten, die ebenfalls aus einer Kette mit bis zu acht unverzweigt oder verzweigt miteinander verknüpften Kohlenstoffatomen bestehen, substituiert sein können, bestehen. Die Alkenylen-Gruppe und die Alkylen-Gruppe können eine oder mehrere C-C-Mehrfachbindungen aufweisen. Die Brückenatome der Gruppe Z können nur aus ungesättigen Kohlenstoff- oder Heteroatomen besteht, wobei die genannten Gruppen unsubstituiert oder substituiert sein können. Die Brückenatome der Gruppe 2 können nur aus gesättigen oder aromatischen Kohlenstoff- oder Heteroatomen besteht, wobei die genannten Gruppe unsubstituiert oder substituiert sein können, so dass die beiden chinoiden Systeme mesomerisch miteinander verbunden sein können.

Die Brücke -Z- kann eine oder mehrere Gruppen, insbesondere der untenstehenden Gruppen in der Form -(Z)n- umfassen, beispielsweise mit n gleich 1, 2, 3 oder 4 oder mehr, die jeweils gleich oder verschieden voneinander sein können.

Z kann ausgewählt sein aus der Gruppe bestehend aus 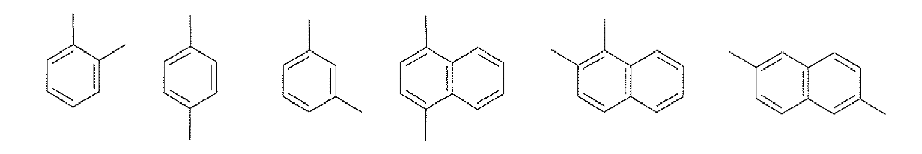 und/oder ausgewählt aus der Gruppe bestehend aus 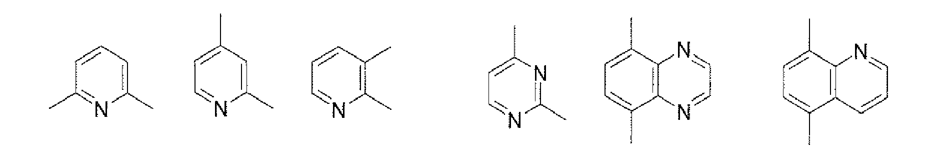 und/oder ausgewählt aus der Gruppe bestehend aus 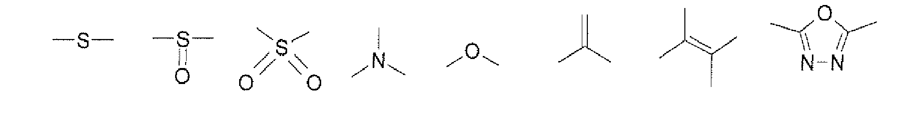 wobei die angegebenen Brücken auch substituierte Brücken wie beispielsweise -NR-, -(C=X)-, -CR1=CR2- mit umfassen,

und/oder ausgewählt aus der Gruppe bestehend aus Carboxy- - (CO)-, Carbimid- -(CNR)-, Thiophenolen-, Furanylen-, 1,3,4-Oxdiazolylen-, Triazin-, Tetrazinylen-, Pyranylen-, Thiopyranylen-, Dithiinylen-, Phosphorinylen-, Phthalsäureanhydrid, Phthalsäureimid bzw. Dithiazol-Rest.

Die aromatischen Ringe oder angegebenen Carbo- oder Heterobrücken können jeweils substituiert oder unsubstituiert sein. X kann ein einfach oder doppelt substituiertes Kohlenstoffatom, ein einfach substituiertes Stickstoffatom oder =O oder =S sein, vorzugsweise ausgewählt aus einer der obenstehenden Gruppen oder Untergruppen.

Die Reste R¹ bzw R² können verschieden von den Resten R¹ bzw R²

der Verbindungsgrundstrukturen 1 bis 33 sein.

Außerdem besteht die Möglichkeit, dass die beiden chinoiden Strukturen auf irgendeine Art und Weise direkt miteinander verknüpft sind.

### Darstellung der chinoiden Strukturen

Sämtliche nachfolgend beschriebenen Synthesen von Chinonverbindungen sind hiermit vollumfänglich durch Inbezugnahme in die vorliegende Erfindung mit eingeschlossen und von dieser erfasst.

Häufig werden die entsprechenden Substitutionsmuster im zu oxidierendem Edukt erzeugt. 1,4-Chinone lassen sich am Besten durch Oxidation der entsprechenden Hydrochinone (W. T. Sumerford, D. N. Dalton, J. Am. Chem. Soc. 1944, 66, 1330; J. Miller, C. Vasquez, 1991 Patent US506836;K. Koch, J. Vitz, J. Prakt. Chem. 2000, 342/8 825-7)oder der fluorierten und/oder chlorierten Aromaten darstellen.(A. Roedig at al. Chem. B. 1974, 107, 558-65; O.I.Osina, V.D. Steingarz, Zh. Org. Chim. 1974, 10, 329; V.D. Steingarz at al Zh. Org. Chim. 1970, 6/4, 833).

1,3-Indandionverbindungen wurden von V. Khodorkovsky at al synthetisiert.( V. Khodorkovsky at al Tetrahedron Lett. 1999, 40, 4851-4)

N,N'-Dicyan-1,4-chinondiimine sind entweder durch Einwirkung von N,N'-Bistrimethylsilylcarbodiimid auf 1,4-Chinonverbindungen (A. Aumüller, S. Hünig, Liebigs Ann. Chem., 1986, 142-64,) oder durch Oxidation entsprechender N,N'-Dicyan-1,4-diaminverbindungen (G. D. Adreetti, S. Bradamante, P. C. Pizzarri, G. A. Pagani, Mol. Cryst. Liq. Cryst. 1985, 120, 309-14) zugänglich, wobei die N,N'-Dicyan-1,4-diaminverbindungen durch Cyanierung von Phenylen-1,4-diamin mit Cyanhalogeniden oder durch Entschwefelung entsprechender Thioharnstoffderivate erhalten werden können.

Einfache Tetracyanochinondimethane können über das 1,4-Cyclohexandion durch Kondensation in Benzen mit Ammoniumacetatpuffer am Wasserabscheider und nachfolgender Oxidation durch Brom dargestellt werden (D. S. Acker, W. R. Hertler, J. Am. Chem. Soc. 1962, 84, 3370). Weiterhin konnten ebenfalls Hertler und Mitarbeiter zeigen, dass diese Verbindungen über 1,4-Xylen und deren Analoge durch Seitenkettenbromierung, Substitution mittels Cyanid, Kondensation mit Kohlensäurediethylester, Überführung der Carbonsäuremethylestergruppierungen in Cyanidgruppen und anschließender Oxidation synthetisierbar sind (J. Org. Chem. 1963, 28, 2719).

Akzeptor-substituierte Tetracyanochinondimethane können aus dem Natriumsalz des t-Butyl-malonsäuredinitril's und Akzeptorsubstituierten 1,4-Dihalogenaromaten dargestellt werden (R. C. Wheland, E. L. Martin, J. Org. Chem., 1975, 40, 3101).

Es gelang außerdem aus 1,4-Dihalogenaromaten Pd-katalysiert mit Malodinitril-Anion und nachfolgender Oxidation Tetracyanochinondimethane darzustellen (S. Takahashi at. al. , Tetrahedron Letters, 1985, 26, 1553).

Chinoide 1,4-Polyphenylene E. A. Shalom, J. Y. Becker, I, Agranat, Nouveau Journal de Chemie 1979, 3, 643-5.

Heteroannelierte Chinone wurden über mehrstufige Syntheseweg dargestellt. (B. Skibo at al, J. Med. 1991, 34, 2954-61; H. Bock, P. Dickmann, H. F. Herrmann, Z. Naturforsch. 1991, 46b, 326-8, J. Druey, P. Schmidt, Helv. Chim. Acta 1950, 140, 1080-7)

Verbrückte chinoide Verbindungen werden dargestellt von M. Matsuoka, H. Oka, T. Kitao, Chemistry Letters, 1990, 2061-4; J. Dieckmann, W. R. Hertler, R. E. Sensen, J. A. C. S. 1963, 28, 2719-24 ; K. Takahashi, S. Tarutani, J. C. S. Chem. Comm. 1994, 519-20; N.N. Woroschzov, W. A. Barchasch, Doklady Akad. SSSR 1966, 166/3, 598.

Annelierte TCNQ-Verbindungen werden dargestellt von M. Matsuoka, H. Oka, T. Kitao, Chemistry Letters, 1990, 2061-4; B. S. Ong, B. Koeshkerian, , J. Org. Chem. 1984, 495002-3.

Pyrazino-TCNQ-Verbindungen lassen sich über 5,8-Diiodochinoxaline Palladium-katalysiert mit dem Natriumsalz des Malodinitrils darstellen.(T. Miyashi at al, J. Org. Chem. 1992, 57, 6749-55)

Pyrazino-TCNQ-Verbindungen sowie weitere heteroannelierte Derivate lassen sich auf verschiedene Weise herstellen (Y. Yamashita at al Chemistry Letters, 1986, 715-8, F. Wudl at al, J. Org. Chem. 1977, 421666-7).

Annelierte DCNQI-Verbindungen lassen sich über die entsprechenden Chinone nach Hünig synthetisieren (J. Tsunetsugu at al, Chemistry Letters, 2002, 1004-5).

Heteroannelierte DCNQI-Verbindungen lassen sich über die entsprechenden Chinone nach Hünig synthetisieren (T. Suzuki at al, J. Org. Chem. 2001, 66, 216-24; N. Martin at al, J. Org. Chem. 1996, 61, 3041-54; K. Kobayashy at al, Chemistry Letters, 1991, 1033-6; K. Kobayashy, K. Takahashi, J. Org. Chem. 2000, 65, 2577-9).

Heterocyclische Chinoide Derivate lassen sich herstellen nach N. F. Haley, J. C. S. Chem. Comm. 1979, 1031, F. Weydand, K. Henkel Chem. B. 1943, 76, 818; H. J. Knackmuss Angew. Chem. 1973, 85, 16; K.Fickentscher, Chem. B. 1969, 102, 2378-83, D. E. Burton at al J. Chem. Soc. (C) 1968, 1268-73.

Chinoide Strukturen mit unterschiedlichen Resten X, Y wurden in verschiedenen Arbeitskreisen synthetisiert (T. Itoh, N. Tanaka, S. Iwatsuki, Macromolecules 1995, 28, 421-4; J. A. Hyatt, J. Org. Chem. 1983, 48 129-31; M. R. Bryce et al, J. Org. Chem. 1992, 57, 1690-6; A. Schönberg, E. Singer, Chem. Ber. 1970, 103, 3871-4; S. Iwatsuki, T. Itoh, H. Itoh Chemistry Letters, 1988, 1187-90; T. Itoh, K. Fujikawa, M. Kubo, J. Org. Chem. 1996, 61, 8329-31; S. Iwatsuki, T. Itoh, T. Sato, T. Higuchi, Macromolecules, 1987, 20, 2651-4; T. Itoh et al Macromolecule2000, 33, 269-77; B. S. Ong, B. Koeshkerian, , J. Org. Chem. 1984, 495002-3; H. Junek, H. Hamböck, B. Hornischer, Mh.Chem.1967, 98, 315-23; P.W.Pastors et al Doklady Akad. SSSR 1972, 204, 874-5; A. R. Katritzky et al Heterocyclic Chem. 1989, 26, 1541-5; N. N. Vorozhtsov, V. A. Barkash, S. A. Anichkina, Doklady Akad. SSSR 1966, 166, 598).

Tetraacetylchinonmethan-Verbindungen bzw. deren reduzierte Formen sind über 1,4-Benzochinon und Acetylaceton erhältlich (J. Jenik, Chemicky prumysl 1985 35/60 1547, R. J. Wikholm J. Org. Chem. 1985, 50, 382-4; E. Bernatek, S. Ramstad Acta Chem. Scand. 1953, 7, 1351-6).

Ditrifluoracetamide lassen sich mittels Trifluoressigsäure über aromatische 1,4-Diamine herstellen (R. Adams, J. M. Stewart J. A. C. S. 1952,20, 3660-4). Durch Oxidation mit Pb(IV)-acetat kann das Diimin erhalten werden.

Weitere Diimid- bzw. amidstrukturen wurden hergestellt von B.C.McKusick at al J. A. C. S. 1958, 80, 2806-15.

### Beispiel 1

### N,N'-Dicyan-2,5-dichlor-1,4-benzochinondiimin

3 Einheiten N,N'-Dicyan-2,5-dichlorbenzen-1,4-diamin in 200 Einheiten Eisessig unter Rühren bei 20°C suspendieren, 13 Einheiten Blei-(IV)-tetraacetat zusetzen. So lange rühren bis der gesamte Ausgangsstoff oxidiert ist. Das ausgefallene gelb/braune Produkt absaugen und aus Benzen umkristallisieren. Ausbeute: 64 % Fp. : 225°C

### Beispiel 2

### N,N'-Dicyan-2,3,5,6-tetrafluor-1,4-benzochinondiimin

1,5 Einheiten 2,3,5,6-Tetrafluor-1,4-benzochinon werden mit 7,6 Einheiten Titantetrachlorid in 70 Einheiten Methylenchlorid versetzt. Der gebildete gelbe Komplex wird mit 7,5 Einheiten Bis-(trimethylsilyl)-carbodiimid in 15 Einheiten Methylenchlorid bei Raumtemperatur unter Rühren zur Reaktion gebracht und nach 4h auf Eis gegeben. Die wässrige Phase wird zweimal mit Methylenchlorid extrahiert. Die vereinigten organischen Phasen werden mit Magnesiumchlorid getrocknet, filtriert, im Vakuum eingeengt und mit Petrolether ausgefällt und erneut abgesaugt. Der erhaltene Feststoff wird aus einem Gemisch von Toluen/Methylcyclohexan umkristallisiert. Ausbeute: 48%, Fp. : 205°C

### Matrixmaterialien

In der vorliegenden Erfindung werden geeignete Dotanden für organische halbleitende Materialien wie Lochtransportmaterialen **HT** beschrieben, die üblicherweise in OLEDs oder organischen Solarzellen verwendet werden. Die halbleitenden Materialien sind vorzugsweise intrinsisch lochleitend. Für erfindungsgemäße Dotanden des Chinon-Typs kann das Folgende gelten.

Das Matrixmaterial kann teilweise (> 10 oder > 25 Gew.-%) oder im Wesentlichen (> 50 Gew.-% oder > 75 Gew.-%)) oder vollständig bestehen aus einem Metallphtalocyanin-Komplex, einem Porphyrin-Komplex, insbesondere Metallporphyrinkomplex, einer Oligothiophen-, Oligophenyl-, Oligophenylenvinylen oder Oligofluoren-Verbindung, wobei das Oligomere vorzugsweise 2-500 oder mehr, vorzugsweise 2-100 oder 2-50 oder 2-10 monomere Einheiten umfasst. Gegebenenfalls kann das Oligomer auch > 4, > 6 oder > 10 oder mehr monomere Einheiten umfassen, insbesondere auch für die oben angegebenen Bereiche, also beispielsweise 4 oder 6-10 monomere Einheiten, 6 oder 10-100 monomere Einheiten oder 10-500 monomere Einheiten. Die Monomere bzw. Oligomere können substituiert oder unsubstituiert sein, wobei auch Block- oder Mischpolymerisate aus den genannten Oligomeren vorliegen können, einer Verbindung mit einer Triarylamin-Einheit oder eine Spiro-Bifluoren-Verbindung. Die genannten Matrixmaterialien können auch in Kombination miteinander vorliegen, gegebenenfalls auch in Kombination mit anderen Matrixmaterialien. Die Matrixmaterialien können elektronenschiebende Substituenten wie Alkyl- oder Alkoxy-Reste aufweisen, die eine verminderte Ionisierungsenergie aufweisen oder die Ionisierungsenergie des Matrixmaterials vermindern.

Die als Matrixmaterial eingesetzten Metallphtalocyaninkomplexe oder Porphyrinkomplexe können ein Hauptgruppenmetallatom oder Nebengruppenmetaliatom aufweisen. Das Metallatom Me kann jeweils 4-, 5- oder 6-fach koordiniert sein, beispielsweise in Form von Oxo- (Me=O), Dioxo- (O=Me=O), Imin-, Diimin-, Hydroxo-, Dihydroxo-, Amino- oder Diaminokomplexen, ohne hierauf beschränkt zu sein. Der Phtalocyaninkomplex oder Porphyrin-komplex kann jeweils teilweise hydriert sein, wobei jedoch vorzugsweise das mesomere Ringsystem nicht gestört wird. Die Phtalocyaninkomplexe können als Zentralatom beispielsweise Magnesium, Zink, Eisen, Nickel, Kobalt, Magnesium, Kupfer oder Vanadyl (= VO) enthalten. Die gleichen oder andere Metallatome bzw. Oxometallatome können im Falle von Porphyrinkomplexen vorliegen.

Insbesondere können solche dotierbaren Lochtransportmaterialen **HT** arylierte Benzidine, beispielsweise N,N'-perarylierte Benzidine oder andere Diamine wie des Typs **TPD** (wobei eine, mehrere oder sämtliche der Arylgruppen aromatische Heteroatome aufweisen können), geeignet arylierte Starburst-Verbindungen wie N,N',N"-perarylierte Starburstverbindungen, wie die Verbindung **TDATA** (wobei eine, mehrere oder sämtliche der Arylgruppen aromatische Heteroatome aufweisen können), sein. Die Arylreste können insbesondere für jede der oben genannten Verbindungen Phenyl, Naphtyl, Pyridin, Chinolin, Isochinolin, Peridazin, Pyrimidin, Pyrazin, Pyrazol, Imidazol, Oxazol, Furan, Pyrrol, Indol oder dergleichen umfassen. Die Phenylgruppen der jeweiligen Verbindungen können durch Thiophengruppen teilweise oder vollständig ersetzt sein.

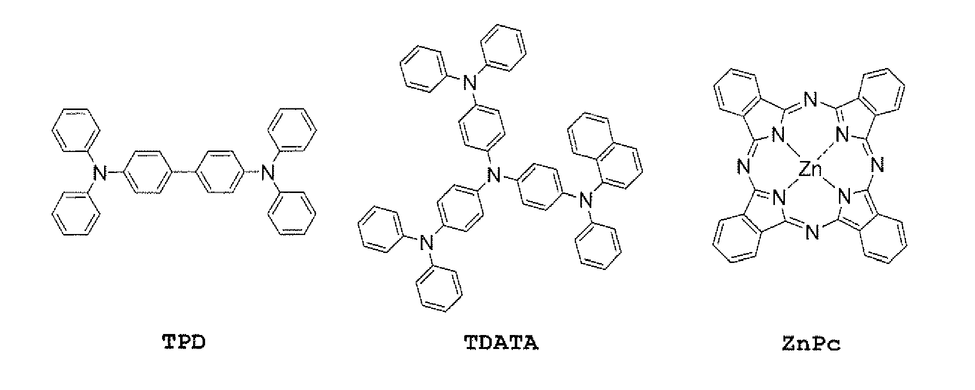

Vorzugsweise besteht das verwendete Matrixmaterial vollständig aus einem Metallphtalocyanin-Komplex, einem Porphyrin-Komplex, einer Verbindung mit einer Triarylamin-Einheit oder einer Spiro-Bifluoren-Verbindung.

Es versteht sich, dass auch geeignete andere organische Matrixmaterialien, insbesondere lochleitende Materialien verwendet werden können, die halbleitende Eigenschaften aufweisen.

### Dotierung

Die Dotierung kann insbesondere derart erfolgen, dass das molare Verhältnis von Matrixmolekül zu Dotand oder im Falle von oligomeren Matrixmaterialien das Verhältnis von Matrixmonomerenanzahl zu Dotand 1:5 bis 1:1000 beispielsweise 1:10 bis 1:100, beispielsweise ca. 1:50 bis 1:100 oder auch 1:25 bis 1:50 beträgt.

### Verdampfung der Dotanden

Die Dotierung des jeweiligen Matrixmaterials (hier vorzugsweise angegeben als löcherleitendes Matrixmaterial HT) mit den erfindungsgemäß zu verwendenden Dotanden kann durch eines oder eine Kombination der folgenden Verfahren hergestellt wird:
a) Mischverdampfung im Vakuum mit einer Quelle für HT und einer für den Dotand.
b) Sequentielles Deponieren von HT und Dotand mit anschliessender Eindiffusion des Dotanden durch thermische Behandlung
c) Dotierung einer HT-Schicht durch eine Lösung von Dotanden mit anschliessendem Verdampfen des Lösungsmittels durch thermische Behandlung
d) Oberflächendotierung einer HT-Schicht durch eine oberflächlich aufgebrachte Schicht von Dotanden

Die Dotierung kann derart erfolgen, dass der Dotand aus einer Precursor-Verbindung heraus verdampft wird, die beim Erhitzen und/oder Bestrahlung den Dotanden freisetzt. Die Bestrahlung kann mittels elektromagnetischer Strahlung, insbesondere sichtbarem Licht, UV-Licht oder IR-Licht erfolgen, beispielsweise jeweils Laserlicht, oder auch durch andere Strahlungsarten. Durch die Bestrahlung kann im wesentlichen die zur Verdampfung notwendige Wärme bereitgestellt werden, es kann auch gezielt in bestimmte Banden der zu verdampfenden Verbindungen bzw. Precursor oder Verbindungskomplexe wie Charge-Transfer-Komplexe eingestrahlt werden, um beispielsweise durch Überführung in angeregte Zustände die Verdampfung der Verbindungen durch Dissoziation der Komplexe zu erleichtern. Es versteht sich, dass die nachfolgend beschriebenen Verdampfungsbedingungen sich auf solche ohne Bestrahlung richten und für Vergleichszwecke einheitliche Verdampfungsbedingungen heranzuziehen sind.

Als Precursorverbindungen könne beispielsweise zum Einsatz kommen:
a) Gemische oder stöchiometrische oder mischkristalline Verbindungen aus dem Dotand und einer inerten, nicht-flüchtigen Substanz, z.B. einem Polymer, Molsieb, Aluminiumoxid, Kieselgel, Oligomeren oder einer anderen organischen oder anorganischen Substanz mit hoher Verdampfungstemperatur, wobei der Dotand vorwiegend durch van-der-Waals Kräfte und/oder Wasserstoffbrückenbindung an dieser Substanz gebunden ist.
b) Gemisch oder stöchiometrische oder mischkristalline Verbindung aus dem Dotand und einer mehr oder weniger Elektronendonor-artigen, nicht flüchtigen Verbindung V, wobei ein mehr oder weniger vollständiger Ladungstransfer zwischen dem Dotanden und der Verbindung V auftritt, wie in Charge-Transfer-Komplexen mit mehr oder weniger elektronenreichen Polyaromaten oder Heteroaromaten oder einer anderen organischen oder anorganischen Substanz mit hoher Verdampfungstemperatur.
c) Gemisch oder stöchiometrische oder mischkristalline Verbindung aus dem Dotand und einer Substanz, welche zusammen mit dem Dotand verdampft und eine gleiche oder höhere Ionisierungsenergie aufweist wie die zu dotierende Substanz HT, so dass die Substanz in dem organischen Matrixmaterial keine Haftstelle für Löcher bildet. Hierbei kann die Substanz erfindungsgemäß auch mit dem Matrixmaterial identisch sein, beispielsweise ein Metallphtalocyanin oder Benzidin-Derivat darstellen. Weitere geeignete flüchtige Co-Substanzen, wie Hydrochinone, 1,4-Phenylendiamine oder 1-Amino-4-hydroxybenze oder sonstige Verbindungen bilden Chinhydrone oder andere Charge-Transfer-Komplexe.

### Elektronisches Bauelement

Unter Verwendung der erfindungsgemäßen organischen Verbindungen zur Herstellung dotierter organischer halbleitender Materialien, die insbesondere in Form von Schichten oder elektrischen Leitungspfaden angeordnet sein können, können eine Vielzahl elektronischer Bauelemente oder diese enthaltende Einrichtungen hergestellt werden. Insbesondere können die erfindungsgemäßen Dotanden zur Herstellung von organischen lichtemitierenden Dioden (OLED), organischen Solarzellen, organischen Dioden, insbesondere solchen mit hohem Gleichrichtungsverhältnis wie 10³-10⁷,vorzugsweise 10⁴-10⁷ oder 10⁵-10⁷ oder organischen Feldeffekttransistoren verwendet werden. Durch die erfindungsgemäßen Dotanden kann die Leitfähigkeit der dotierten Schichten und/oder die Verbesserung der Ladungsträgerinjektion von Kontakten in die dotierte Schicht verbessert werden. Insbesondere bei OLEDs kann das Bauelement eine pin-Struktur oder eine inverse Struktur aufweisen, ohne hierauf beschränkt zu sein. Die Verwendung der erfindungsgemäßen Dotanden ist jedoch auf die oben genannten vorteilhaften Ausführungsbeispiele nicht beschränkt.

### Ausführungsbeispiele

Die Erfindung soll an einigen Ausführungsbeispielen näher erläutert werden.

Die erfindungsgemäß zu verwendenden Verbindungen, insbesondere die vorstehend beispielhaft angebenen Verbindungen aus der vorstehend beschriebenen Stoffklasse der Chinone werden nun in folgender Weise als Dotanden für verschiedene Lochleiter verwendet, die ihrerseits zum Aufbau bestimmter mikroelektronischer oder optoelektronischer Bauelemente, wie z.B. einer OLED, benutzt werden. Hierbei können die Dotanden gleichzeitig nebeneinander mit dem Lochtransportmaterialien der Matrix im Hochvakuum (ca. 2x 10⁻⁴Pa) bei erhöhten Temperaturen verdampft werden. Eine typische Substratbedampfungsrate für das Matrixmaterial ist 0,2 nm/s (Dichte ca. 1,5 g/cm³). Die Bedampfungsraten für die Dotanden können variieren zwischen 0.001 und 0.5 nm/s bei gleicher angenommener Dichte, jeweils entsprechend dem gewünschten Dotierungsverhältnis. Im nachfolgenden werden die Vordampiungstemperaturen der Verbindungen in einer Substratbedampfungseinrichtung angegeben, wobei F4TCNQ unter sonst identischen Bedingungen eine Verdampfungstemperatur von 80°C aufweist, um bei gleicher vorgegebener Zeiteinheit (z.B. fünf Sekunden) eine gleiche Schichtdicke (z.B. 1 nm) auf dem Substrat abzuscheiden, wie die erfindungsgemäß verwendeten Dotanden.

In den folgenden Beispielen wurden die Strommessungen über einen 1 mm langen und ca. 0,5 mm breiten Strompfad aus dem dotierten HT-Material bei 1V durchgeführt. Unter diesen Bedingungen leitet ZnPc praktisch keinen elektrischen Strom.

### Beispiel 1

Dotierung von ZnPc mit N,N'-Dicyan-2,3,5,6-tetrafluoro-1,4-chinondiimin (F4DCNQI)

Die Verdampfungstemperatur T(evap.) beträgt 85°C. Die beiden Komponenten Matrix und Dotand wurden in einem Verhältnis von 50:1 im Vakuum aufgedampft. Die Leitfähigkeit beträgt hierbei 2.4×10⁻² S/cm.

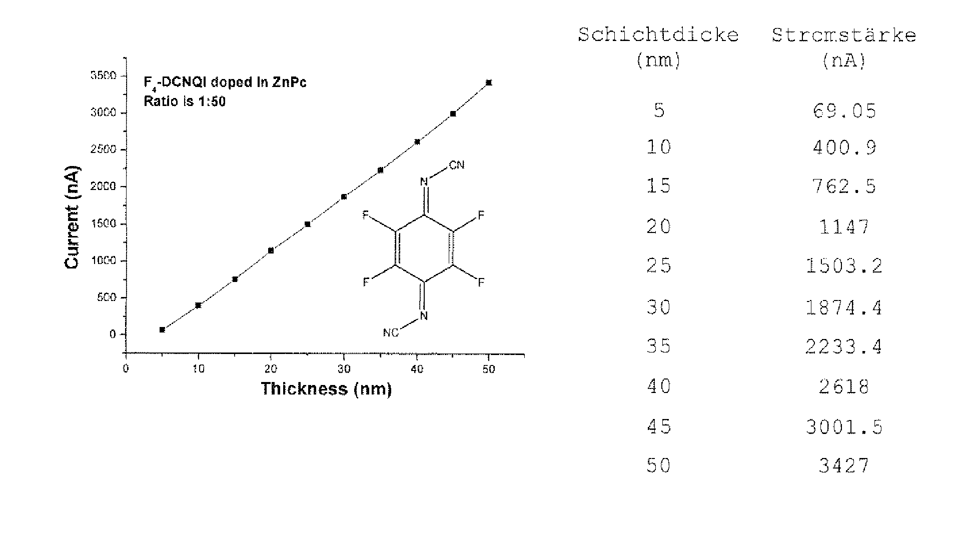

### Beispiel 2

Dotierung von ZnPc mit N,N'-Dicyan-2,5-dichloro-1,4-chinondiimin (C12DCNQI)

Die Verdampfungstemperatur T(evap.) beträgt 114°C. Das Verhältnis der beiden Verbindungen in der aufgedampften Schicht beträgt 1:50 zu Gunsten der Matrix. In der Schicht wurde eine Leitfähigkeit von 1.0x10⁻² S/cm gemessen.

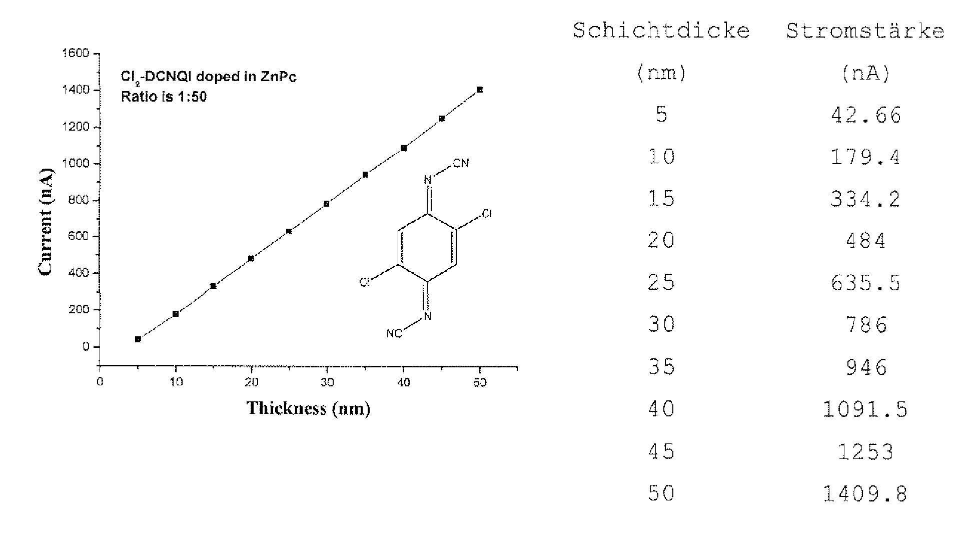

### Beispiel 3

Dotierung von ZnPc mit N,N'-Dicyan-2,5-dichloro-3,6-difluoro-1,4-chinondiimin (C12F2DCNQI)

Die Verdampfungstemperatur T(evap.) beträgt 118°C. Die Schicht wurde im Verhältnis 1:25 (Dotand:Matrix) im Vakuum aufgedampft. Dabei wurde eine Leitfähigkeit von 4.9×10⁻⁴ S/cm gemessen.

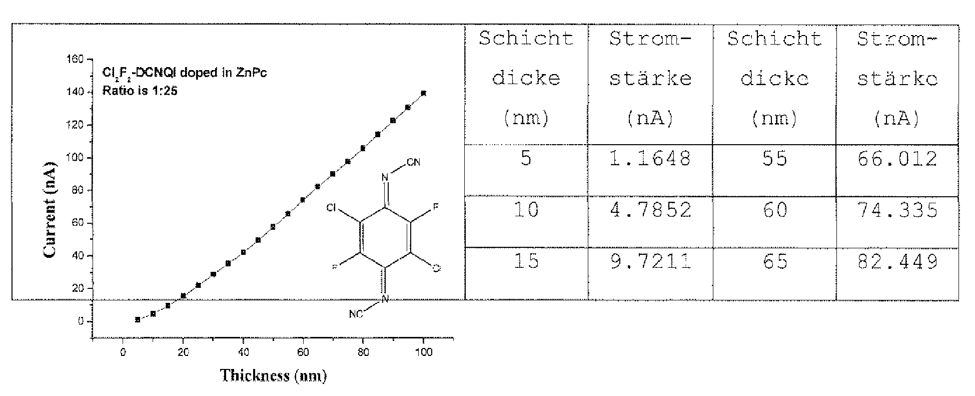

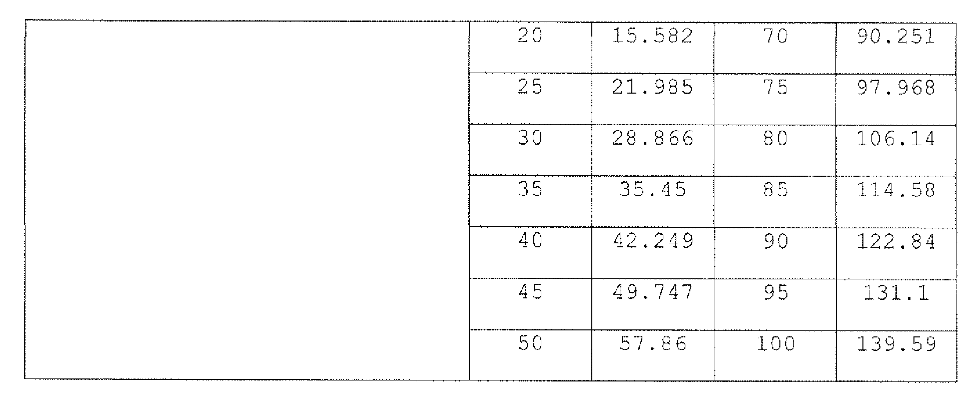

### Beispiel 4

Dotierung von ZnPc mit N,N'-Dicyan-2,3,5,6,7,8-hexafluoro-1,4-naphthochinondiimin (F6DCNNQI)

Die Verdampfungstemperatur T(evap.) beträgt 122°C. Dotand und Matrix wurden im Verhältnis 1:25 auf den Träger im Vakuum aufgedampft. Dabei wurde eine Leitfähigkeit von 2×10⁻³ S/cm erreicht.

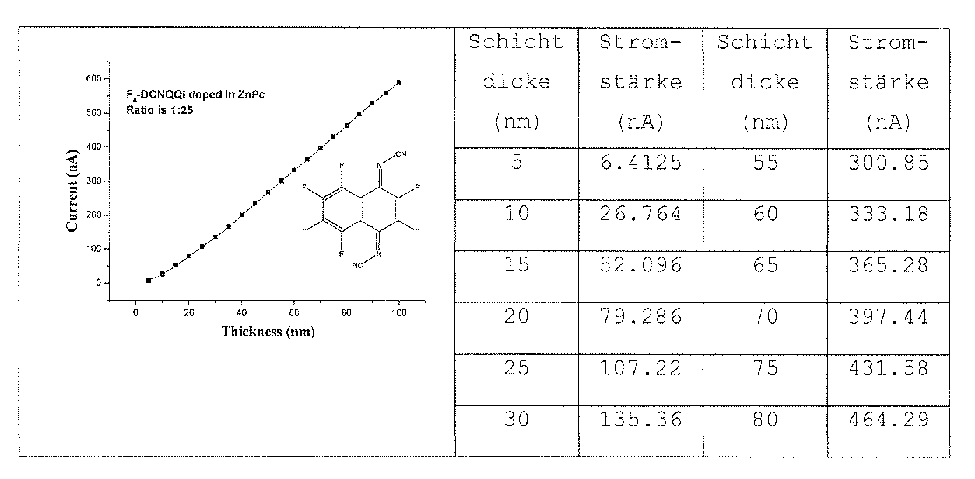

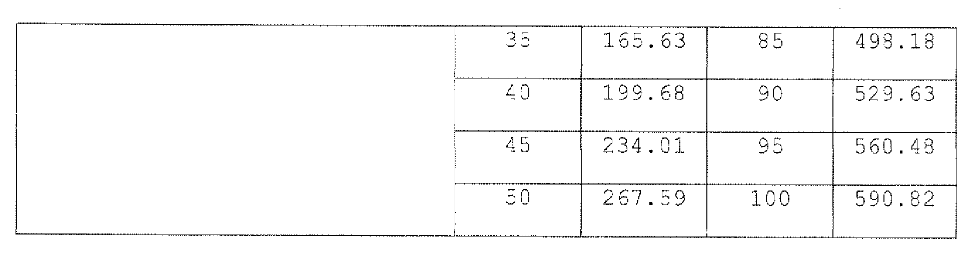

### Beispiel 5

Dotierung von ZnPc mit 1,4,5,8-Tetrahydro-1,4,5,8-tetrathia-2,3,6,7-tetracyanoanthrachinon (CN4TTAQ).

Die Verdampfungstemperatur T(evap.) beträgt 170°C. Die Schicht wurde im Verhältnis 1:25 (Dotand:Matrix) im Vakuum aufgedampft. Dabei wurde eine Leitfähigkeit von 4.5×10⁻⁴ S/cm gemessen.

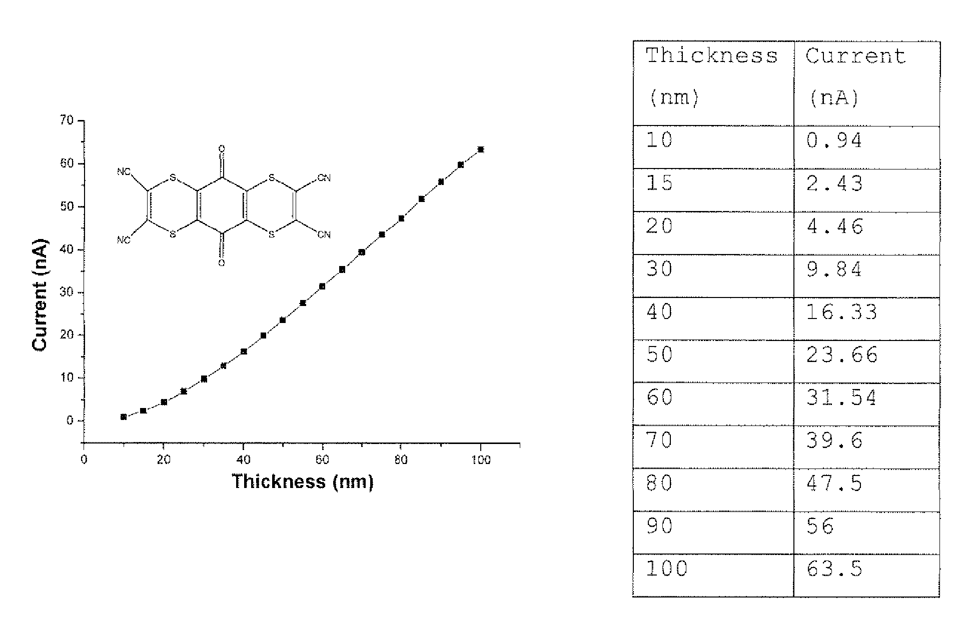

## Patentansprüche

1. Verwendung einer organischen mesomeren Verbindung als organischer Dotand zur Dotierung eines organischen halbleitenden Matrixmaterials zur Veränderung der elektrischen Eigenschaften desselben, wobei die mesomere Verbindung ein Chinon oder Chinonderivat ist und die mesomere Verbindung unter gleichen Verdampfungsbedingungen eine geringere Flüchtigkeit als Tetrafluorotetracyanochinondimethan (F4TCNQ) aufweist, wobei die Flüchtigkeit der mesomeren Verbindung das 0,9-fache, bevorzugt das 0,8-fache von F4TCNQ oder weniger beträgt.

2. Verwendung nach Anspruch 1, **dadurch gekennzeichnet, dass** der Dotand unter sonst gleichen Bedingungen bei gegebenem Matrixmaterial eine genauso hohe oder höhere Leitfähigkeit erzeugt als F4TCNQ.

3. Verwendung nach Anspruch 1 oder 2, **dadurch gekennzeichnet, dass** das mit dem Dotanden dotierte organische halbleitende Matrixmaterial nach einer Temperaturänderung von 100°C auf Raumtemperatur noch ≥ 50% der Leitfähigkeit des Wertes bei 100°C aufweist.

4. Verwendung nach einem der vorangehenden Ansprüche, **dadurch gekennzeichnet, dass** aromatischen Ringe des Chinons oder Chinonderivats perfluoriert sind.

5. Verwendung nach einem der vorangehenden Ansprüche, **dadurch gekennzeichnet, dass** das organische halbleitende Matrixmaterial ausgewählt ist aus acyliertem Benzidin, andere Diaminen, vorzugsweise des Typs TPD, wobei eine, mehrere oder sämtliche der Arylgruppen aromatische Heteroatome aufweisen können, und arylierten Starburst-Verbindungen, vorzugsweise des Typs TDATA, wobei eine, mehrere oder sämtliche der Arylgruppen aromatische Heteroatome aufweisen können.

6. Verwendung nach einem der vorangehenden Ansprüche, **dadurch gekennzeichnet, dass** das molare Dotierungsverhältnis von Dotand zu Matrixmolekül bzw. monomeren Einheit eines polymeren Matrixmoleküls zwischen 1:10 und 1:1000 beträgt.

7. Verwendung nach einem der vorangehenden Ansprüche, **dadurch gekennzeichnet, dass** die mesomere Verbindung die allgemeine 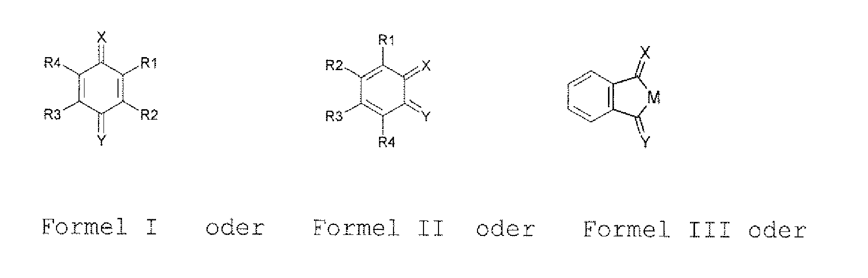 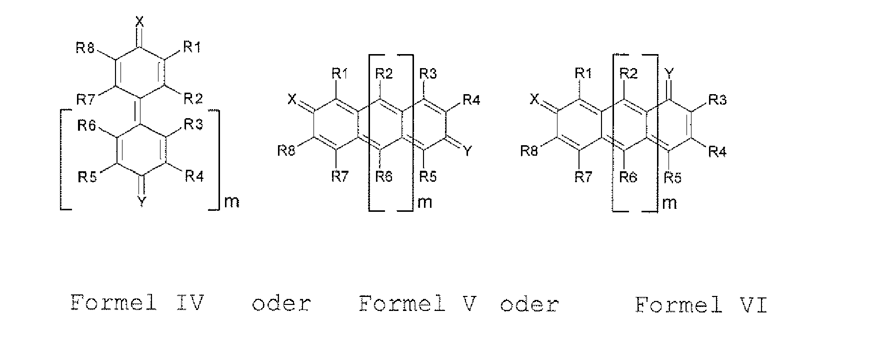 mit m = 1,2,3,4 für Formel IV und
mit m = 0,1,2,3,4 für Formel V oder VI oder 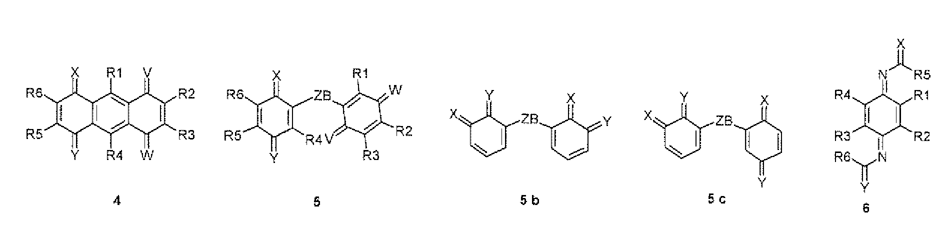 Formel VII oder Formel VIII oder Formel IX oder Formel X oder Formel XI
oder 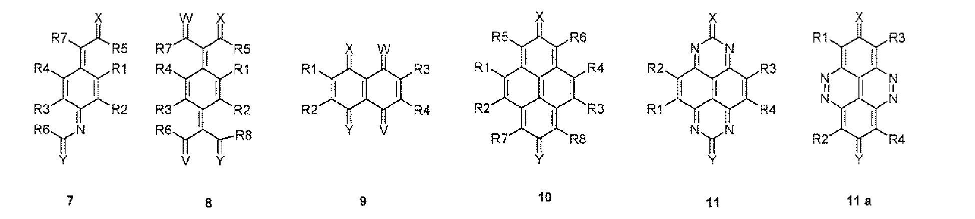 Formel XII oder Formel XIII oder Formel XIV oder Formel XV oder Formel XVI oder Formel XVII
oder 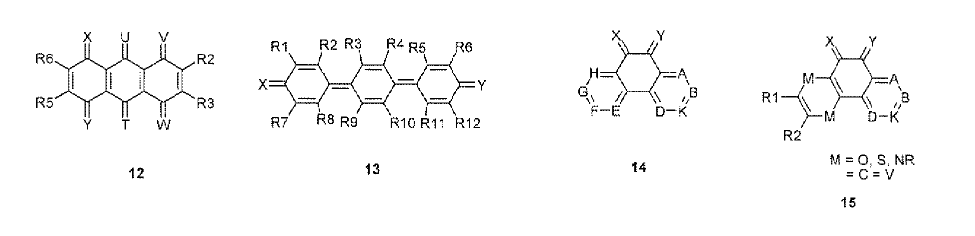 Formel XVIII oder Formel XIX oder Formel XX oder Formel XXI
oder 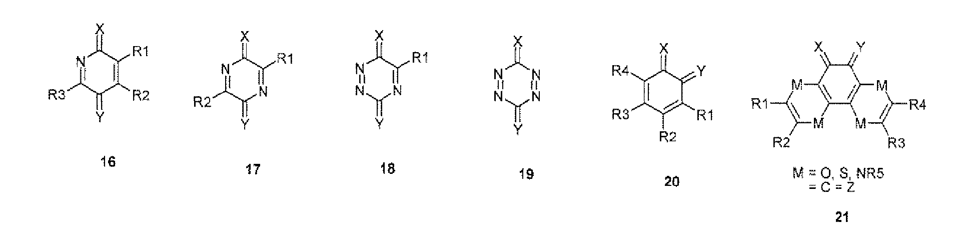 Formel XXII oder Formel XXIII oder Formel XXIV oder Formel XXV oder Formel XXVI oder Formel XXVII
oder 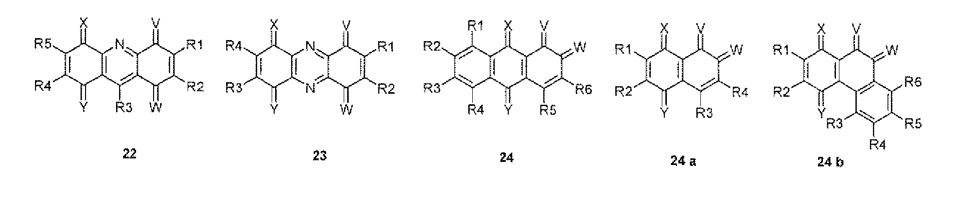 Formel XXVIII oder Formel XXIX oder Formel XXX oder Formel XXXI oder Formel XXXII
oder 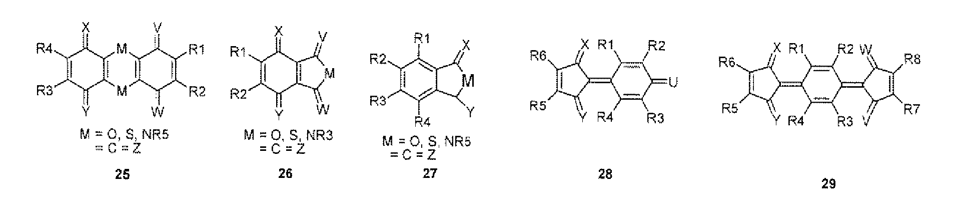 Formel XXXIII oder Formel XXXIV oder Formel XXXV oder Formel XXXVI oder Formel XXXVII 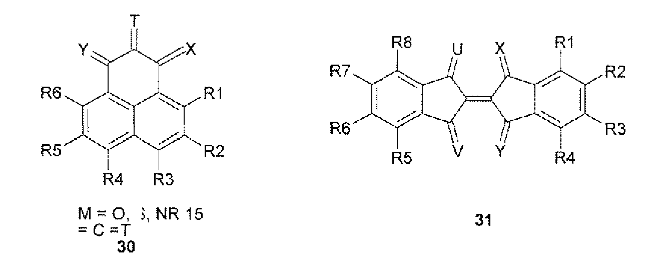 oder Formel XXXVIII oder Formel XXXIX 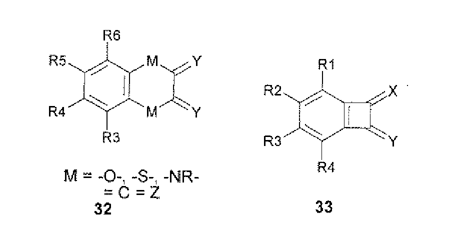 oder Formel XXXX oder Formel XXXXI
aufweist, wobei der chinoide oder aromatische Ring substituiert oder unsubstituiert (R=H) oder mit mindestens einem aromatischen Ring anelliert sein kann, wobei -Mein bivalentes Atom oder eine Gruppe mit einem bivalenten Brückenatom ist und wobei = T, = U, = V, = X, = Y oder = Z doppelbindungsgebundene Atome oder Atomgruppen mit mesomer und/oder induktiv ziehenden Resten sind, und wobei ZB ein zweibindiges Atom oder eine zweibindige mehratomige Brücke ist.

8. Verwendung nach Anspruch 7, **dadurch gekennzeichnet, dass** die Symbole folgende Bedeutung haben:
- M- ist -O-, -S- , -NR- oder -C(=Z)-, vorzugsweise -O-,
- S- oder -NR- oder vorzugsweise -C(=Z)-,
und
= T, = U, = V, = W, = X, = Y oder = Z sind gleich oder verschieden und ausgewählt aus der Gruppe bestehend aus 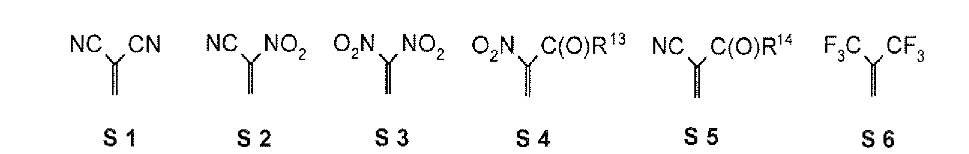 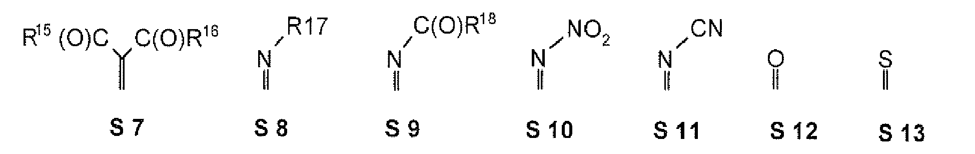 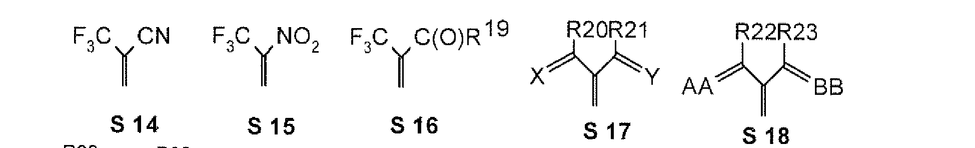 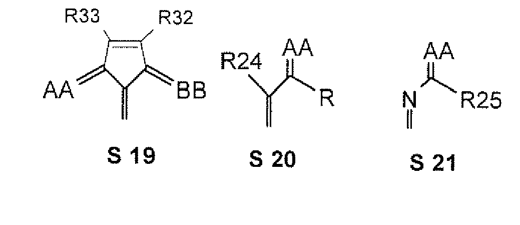 wobei der Substituent AA ausgewählt ist aus der Gruppe bestehend aus 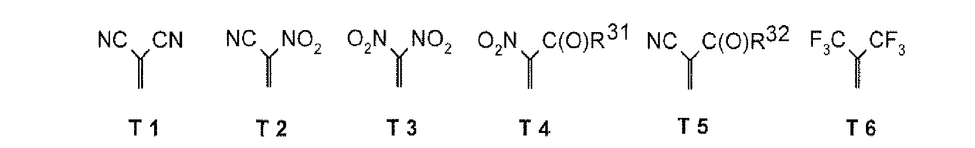 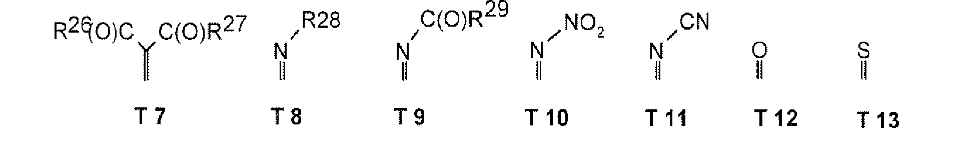 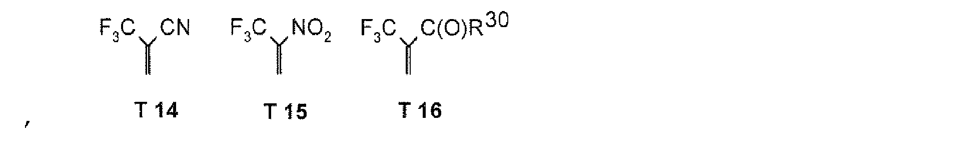 wobei AA mit einem anderen Rest R der Verbindung einen mehrgliedrigen Ring bilden kann,
wobei Z in den Formeln VIII; IX oder X eine direkte Bindung, oder eine einatomige oder mehratomige Gruppe darstellt, die gesättigt oder ungesättigt sein kann, und wobei A, B, D, E, F, G, H, K in den Formeln XX und XXI gleich oder verschieden ist und ausgewählt ist aus der Gruppe =N-, =P-, oder =CR-, wobei R ein Wasserstoffatom oder einen Rest darstellen kann.

9. Organisches halbleitendes Material enthaltend ein organisches Matrixmolekül und einen organischen Dotanden, **dadurch gekennzeichnet, dass** der Dotand ein oder mehrere Verbindungen nach einem der Ansprüche 1 bis 8 sind und das molare Dotierungsverhältnis von Dotand zu Matrixmolekül bzw. monomeren Einheit eines polymeren Matrixmoleküls zwischen 1:5 und 1:1000 beträgt.

10. Verfahren zur Herstellung eines organischen halbleitenden Materials enthaltend ein organisches Matrixmolekül und einen organischen Dotanden nach Anspruch 9, **dadurch gekennzeichnet, dass** eine Substratbedampfungsrate für den Dotanden zwischen 0,001 und 0,5 nm/Sekunde beträgt.

11. Verfahren nach Anspruch 10, **dadurch gekennzeichnet, dass** der Dotand aus einer Precursorverbindung heraus verdampft wird, die beim Erhitzen und/oder Bestrahlen den Dotanden freigibt.

12. Elektronisches Bauelement mit einem organischen halbleitenden Material, welches mit einem organischen Dotanden zur Veränderung der elektronischen Eigenschaften des halbleitenden Matrixmaterials dotiert ist, wobei die Dotierung unter Verwendung zumindest einer oder mehrerer der Verbindungen nach einem der Ansprüche 1 bis 8 erfolgte und das molare Dotierungsverhältnis von Dotand zu Matrixmolekül bzw. monomeren Einheit eines polymeren Matrixmoleküls zwischen 1:5 und 1:1000 beträgt.

13. Elektronisches Bauelement nach Anspruch 12 in Form einer organischen lichtemittierenden Diode (OLED), einer photovoltaischen Zelle, einer organischen Solarzelle, einer organischen Diode oder eines organischen Feldeffekttransistors.
